# EUROPEAN PATENT SPECIFICATION

(11) **EP 3 498 780 B1**
(45) Date of publication and mention of the grant of the patent: **09.06.2021**
(21) Application number: 17839359.1
(22) Date of filing: 04.08.2017
(51) Int. Cl.: C08L 83/04, C08J 5/00, C08K 3/00, H01L 21/56, H01L 23/29, H01L 23/31

(54) **CURABLE PARTICULATE SILICONE COMPOSITION, SEMICONDUCTOR MEMBER COMPRISING CURABLE PARTICULATE SILICONE COMPOSITION, AND MOLDING METHOD FOR SEMICONDUCTOR MEMBER COMPRISING CURABLE PARTICULATE SILICONE COMPOSITION**
HÄRTBARE TEILCHENFÖRMIGE SILIKONZUSAMMENSETZUNG, HALBLEITERELEMENT MIT HÄRTBARER TEILCHENFÖRMIGER SILIKONZUSAMMENSETZUNG UND FORMVERFAHREN FÜR HALBLEITERELEMENT MIT HÄRTBARER TEILCHENFÖRMIGER SILIKONZUSAMMENSETZUNG
COMPOSITION DE SILICONE PARTICULAIRE DURCISSABLE, ÉLÉMENT SEMI-CONDUCTEUR COMPRENANT LA COMPOSITION DE SILICONE PARTICULAIRE DURCISSABLE, ET PROCÉDÉ DE MOULAGE DESTINÉ À UN ÉLÉMENT SEMI-CONDUCTEUR COMPRENANT LA COMPOSITION DE SILICONE PARTICULAIRE DURCISSABLE

(30) Priority: 08.08.2016 JP 2016155385
(43) Date of publication of application: 19.06.2019
(73) Proprietor: Dow Toray Co., Ltd., Tokyo (JP)
(72) Inventor: YAMAZAKI, Ryosuke, Ichihara-shi Chiba 299-0108 (JP)
(74) Representative: Murgitroyd & Company
(86) International application number: PCT/JP2017/028386
(87) International publication number: WO 2018/030288

(56) References cited:
- WO-A1-2013/051600
- WO-A1-2015/194158
- WO-A1-2015/194158
- WO-A1-2016/103654
- WO-A1-2016/136243
- JP-A- 2013 221 075
- JP-A- 2016 124 967

## Description

### TECHNICAL FIELD

The present invention relates to a curable particulate silicone composition particularly suitable for overmold molding, and pellet molded from the curable particulate silicone composition. Further, the present invention relates to a cured product using the curable particulate silicone composition or a pellet, a molding method of the cured product, and a semiconductor device including the cured product.

### BACKGROUND ART

Curable silicone compositions are utilized in a wide range of industrial fields because they are cured to form cured products having excellent heat resistance, cold resistance, electrical insulation, weather resistance, water repellency, and transparency. The cured product of such a curable silicone composition is also suitable as a sealant for optical materials and semiconductor devices because it is hardly discolored as compared with other organic materials, and physical properties are less deteriorated.

The present applicant has proposed, in Patent Document 1 and Patent Document 2, a so-called hot melt curable particulate silicone composition and a reactive silicone composition. These hot-melt silicone compositions are easy to handle for handling workability, particularly used for overmold molding, etc. On the other hand, cured products obtained by curing these silicone compositions provide a large average linear expansion coefficient especially at a temperature of from room temperature to a high temperature of about 150°C, and its hardness and toughness are insufficient in some cases. Furthermore, since the cured products obtained by curing these silicone compositions change the storage modulus significantly at a high temperature of particularly about 250°C., further improvements in physical properties have been desired for application to semiconductor applications, especially power semiconductor applications, which are expected to operate at high temperatures.

On the other hand, the present applicant has proposed a liquid (pasty) curable silicone composition having an average linear expansion coefficient (average linear expansion coefficient) of 200 ppm/°C. or less at 25°C. to 200°C. However, these liquid or pasty curable silicone compositions are excellent in physical properties such as average linear expansion coefficient, but since they are liquid, it is difficult to use for molding by overmolding, and the warp or breakage problem may occur due to insufficient mechanical strength of the cured product.

Document WO 2015/194158 discloses in its example 10 a composition comprising a particulate hot melt silicone with a regular spherical shape and a diameter of 5 to 10 microns, a linear polysiloxane having SiH end groups and an inorganic filler having a particle size of 15 microns in an amount of about 450 parts per 100 parts of the silicone particulate component.

### Prior Art Documents

### Patent Documents

[Patent Document 1] PCT/JP2016/000959
[Patent Document 2] JP 2014-009322 A
[Patent Document 3] JP 2014-528488 T

### SUMMARY OF THE INVENTION

### Problems to be Solved by the Invention

An object of the present invention is to provide a curable particulate silicone composition having hot-melt properties, excellent handling workability such as overmold molding and curing characteristics, and excellent hardness and toughness at a temperature of from room temperature to a high temperature of about 250°C, and a pellet or the like formed by molding the curable particulate silicone composition. Another object of the present invention is to provide a semiconductor device member composed of such a curable particulate silicone composition and a cured product such as pellets, a semiconductor device having the cured product, and a molding method of the cured product.

### Means for Solving the Problems

The curable particulate silicone composition of the present invention contains:
(A) 100 parts by mass of hot-melt silicone fine particles having an average primary particle diameter observed with an optical microscope of 1 to 5000 µm, having a softening point of 30°C. or higher and having a hydrosilylation reactive group and/or a radical reactive group;
(B) 500 to 4000 parts by mass of an inorganic filler having an average particle diameter observed with an optical microscope of 10.0 µm or more and
(C) a curing agent,
wherein when cured, the curable particulate silicone composition provides a cured product that has an average linear expansion coefficient at a temperature range of 25°C. to 200°C. of 30 ppm/°C. or less and the ratio of the value of the storage modulus at -50°C. (G'-₅₀) to the value of the storage modulus at 250°C. (G'₂₅₀): (G'₋₅₀/G'₂₅₀) is in the range of 1/1 to 1/50.

Component (B) is preferably a filler which does not have a softening point or does not soften below the softening point of component (A), and is substantially an inorganic filler having an average particle diameter of 10.0 µm or more. From the viewpoint of the functionality and physical properties of the cured product, component (B) is preferably a reinforcing filler, a white pigment, a thermally conductive filler, a conductive filler, a phosphor, or a mixture of at least two of these. In particular, since the hardness at room temperature to high temperature and the rate of change in storage modulus are small, component (B) is a spherical inorganic filler having an average particle diameter of 10.0 µm or more.

Component (A) is preferably silicone fine particles including (A₁) a resinous organopolysiloxane, (A₂) an organopolysiloxane crosslinked product obtained by partially crosslinking at least one organopolysiloxane, (A₃) a block copolymer composed of a resinous organosiloxane block and a chained organosiloxane block, or a mixture of at least two of these. In addition, it is particularly preferable that component (A) is true-spherical silicone fine particles in which 10 mol% or more of the silicon atom-bonded organic groups in component (A) is an aryl group and the average primary particle diameter thereof is 1 to 10 µm, and such true-spherical silicone fine particles are preferably obtained by use of a spray dryer or the like.

The content of component (B) is in the range of 500 to 4000 parts by mass, with regard to 100 parts by mass of component (A). In the composition of the present invention, it is possible to blend component (B) in a large amount, and component (B) can be blended in a quantitative range of 80 mass% or more, 85 mass% or more, and 90 mass% or more of the entire composition, and is suitable.

Further, it is preferable that the cured product obtained by curing the composition of the present invention does not have a definite inflection point in a change in the linear expansion coefficient at a temperature range of 20°C. to 300°C., preferably in the range of 25°C. to 200°C. More preferably, even when the storage modulus changes in the range of -50°C. to 250°C., it is desirable not to have a definite inflection point.

The curable particulate silicone composition of the present invention is preferably in the form of pellets or sheets.

The curable particulate silicone composition of the present invention can be used in the form of a cured product, and can be used as a member for a semiconductor device.

The curable particulate silicone composition of the present invention and the cured product thereof can be used in a semiconductor device, and a power semiconductor device in which a sealant is formed by the cured product is provided. In particular, the curable particulate silicone composition of the present invention can be suitably used for overmold molding, and since the cured product thereof is excellent in hardness at room temperature to high temperature and tough, a semiconductor device having a structure in which a semiconductor element or a semiconductor circuit board is overmolded by the cured product, particularly, a power semiconductor device is suitably provided.

The method of molding the curable particulate silicone composition of the present invention comprises at least the following steps.
(I) a step of heating and melting the curable particulate silicone composition according to any one of claims 1 to 8 to the softening point of component (A) or higher;
(II) a step of injecting the curable silicone composition obtained in step (I) into a mold or a step of distributing the curable silicone composition obtained in step (I) to a mold by clamping; and
(III) a step of curing the curable silicone composition injected in step (II).

The above molding method includes transfer molding, compression molding, or injection molding, and the curable particulate silicone composition of the present invention is suitably used as a material for these molding techniques. Furthermore, the curable particulate silicone composition of the present invention can be suitably used as a molding material in a so-called overmold method, which is a step of coating a semiconductor element or a semiconductor circuit board with the cured product by overmold molding.

### Effects of the Invention

The curable particulate silicone composition (including pellets) of the present invention has hot-melt properties, is excellent in handling workability such as overmold molding and curing characteristics, and provides a cured product having hardness and toughness at a temperature of from room temperature to high temperature of about 250°C. In addition, the cured product of the present invention is useful as a member of a semiconductor device, and by using the molding method of the present invention, particularly overmold molding, these cured products can be efficiently produced in accordance with applications.

### BRIEF DESCRIPTION OF THE DRAWINGS

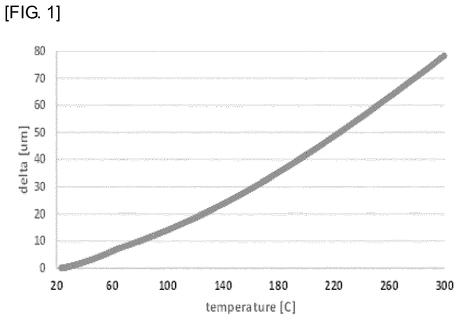

[Fig. 1] The linear expansion coefficient curve of the cured product of Example 1 at 20°C. to 300°C. (the horizontal axis represents temperature (unit: °C.) and the vertical axis represents change in size (delta, unit: µm)).

### MODE FOR CARRYING OUT THE INVENTION

### Curable Particulate Silicone Composition

The curable particulate silicone composition of the present invention contains the following components (A) to (C) and is cured to give a cured product excellent in hardness and toughness from room temperature to high temperature.

The curable particulate silicone composition of the present invention is according to claim 1 and as described above.

Hereinafter, each component and optional component of the composition will be described. In the present invention, the term "average particle diameter" means the primary average particle diameter of the particles unless otherwise defined.

Component (A) is hot-melt silicone fine particles having a softening point of 30°C or higher and having a hydrosilylation reactive group and/or a radical reactive group, and provides good hot-melt properties to the composition and is cured by the curing agent (C).

Examples of the hydrosilylation reactive group in component (A) include an alkenyl group having 2 to 20 carbon atoms such as vinyl groups, allyl groups, butenyl groups, pentenyl groups, hexenyl groups, heptenyl groups, octenyl groups, nonenyl groups, decenyl groups, undecenyl groups, and dodecenyl groups, and a silicon atom bonded hydrogen atom. As the hydrosilylation reactive group, an alkenyl group is preferable. The alkenyl group may be linear or branched, and is preferably a vinyl group or a hexenyl group. Component (A) preferably has at least two hydrosilylation reactive groups in one molecule.

Examples of the group bonded to a silicon atom other than the hydrosilylation reactive group in component (A) include an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, an aralkyl group having 7 to 20 carbon atoms, an alkoxy group, and a hydroxyl group. Specific examples thereof include alkyl groups such as methyl, ethyl, propyl, butyl, pentyl, hexyl, heptyl, octyl, nonyl, decyl, undecyl, and dodecyl; aryl groups such as phenyl, tolyl, xylyl, naphthyl, anthracenyl, phenanthryl, and pyrenyl; aralkyl groups such as phenethyl and phenylpropyl; groups in which a part or all of the hydrogen atoms bonded to these groups are substituted with a halogen atom such as a chlorine atom and a bromine atom; and alkoxy groups such as methoxy, ethoxy, and propoxy. In particular, a phenyl group and a hydroxyl group are preferable.

Examples of radical reactive groups in component (A) include alkyl groups having 1 to 20 carbon atoms, such as methyl, ethyl, propyl, butyl, pentyl, hexyl, heptyl, octyl, nonyl, decyl, undecyl, and dodecyl; alkenyl groups having 2 to 20 carbon atoms, such as vinyl, allyl, butenyl, pentenyl, hexenyl, heptenyl, octenyl, nonenyl, decenyl, undecenyl, and dodecenyl; acryl-containing groups such as 3-acryloxypropyl and 4-acryloxybutyl; methacryl-containing groups such as 3-methacryloxypropyl and 4-methacryloxybutyl; and a silicon atom bonded hydrogen atom. As the radical reactive group, an alkenyl group is preferable. The alkenyl group may be linear or branched, and is preferably a vinyl group or a hexenyl group. Component (A) preferably has at least two radical reactive groups in one molecule.

Examples of the group bonded to a silicon atom other than the radical reactive group in component (A) include a halogen-substituted alkyl group having 1 to 20 carbon atoms, an aryl group having 6 to 20 carbon atoms, a halogen-substituted aryl group having 6 to 20 carbon atoms, an aralkyl group having 7 to 20 carbon atoms, an alkoxy group, and a hydroxyl group, and the same groups as those described above are exemplified. In particular, a phenyl group and a hydroxyl group are preferable. In particular, in component (A), it is preferable that 10 mol% or more of the total organic groups in the molecule be an aryl group, in particular, a phenyl group.

Component (A) itself has hot-melt properties and is cured by the curing agent (C) described later. Such component (A) is preferably silicone fine particles including (A₁) a resinous organopolysiloxane, (A₂) an organopolysiloxane crosslinked product obtained by crosslinking at least one organopolysiloxane, (A₃) a block copolymer composed of a resinous organosiloxane block and a chained organosiloxane block, or a mixture of at least two of these.

Component (A₁) is a resinous organopolysiloxane having a hydrosilylation reactive group and/or a radical reactive group, and is preferably a hot-melt resinous organopolysiloxane having a large number of T-units or Q-units and an aryl group. Examples of such component (A₁) include MQ resins, MDQ resins, MTQ resins, MDTQ resins, TD resins, TQ resins, and TDQ resins comprised of an arbitrary combination of triorganosiloxy units (M-units) (organo groups are methyl groups only, methyl groups and vinyl groups or phenyl groups), diorganosiloxy units (D-units) (organo groups are methyl groups only, methyl groups and vinyl groups or phenyl groups), monoorganosiloxy units (T-units) (organo groups are methyl groups, vinyl groups, or phenyl groups), and siloxy units (Q-units). It is preferable that component (A₁) has at least two hydrosilylation reactive groups and/or radical reactive groups in the molecule, and 10 mol% or more of the total organic groups in the molecule is an aryl group, particularly, a phenyl group.

In addition, since component (A₂) is formed by crosslinking at least one organopolysiloxane, cracks are hardly generated when the component is cured by the curing agent (C), and the curing shrinkage can be reduced. Here, "crosslinking" means linking the organopolysiloxane as a raw material by a hydrosilylation reaction, a condensation reaction, a radical reaction, a high energy ray reaction, or the like. Examples of the hydrosilylation reactive group and the radical reactive group (including the high energy ray reactive group) include the same groups as those described above, and examples of the condensation reactive group include a hydroxyl group, an alkoxy group, and an acyloxy group.

The unit constituting component (A₂) is not limited, and siloxane units and siloxane units containing silalkylene groups are exemplified, and it is preferable to have a resinous polysiloxane unit and a chained polysiloxane unit in the same molecule because they impart adequate hardness and mechanical strength to the obtained cured product. That is, component (A₂) is preferably a crosslinked product of a resinous organopolysiloxane and a chained organopolysiloxane (including a linear or branched chain organopolysiloxane). By introducing the resinous organopolysiloxane structure-chained organopolysiloxane structure into component (A₂), component (A₂) exhibits good hot-melt properties, and the curing agent (C) exhibits good curing properties.

Component (A2) is any one of the following (1) to (3):
(1) One obtained by linking a resinous organopolysiloxane structure-chain organopolysiloxane structure in the molecule by an alkylene linkage via a hydrosilylation reaction of an organopolysiloxane having at least two alkenyl groups in one molecule and an organopolysiloxane having at least two silicon atom bonded hydrogen atoms in one molecule;
(2) One obtained by linking a resinous organopolysiloxane structure-chain organopolysiloxane structure in the molecule by a siloxane linkage or an alkylene linkage via a radical reaction of an organic peroxide of at least two organopolysiloxanes having at least two radical reactive groups in one molecule;
(3) One obtained by linking a resinous organopolysiloxane structure-chain organopolysiloxane structure in the molecule by a siloxane (-Si-O-Si-) linkage via a condensation reaction of at least two organopolysiloxanes.
Such component (A₂) has a structure in which organopolysiloxane moieties of the resin structure-chain structure are linked by an alkylene group or new siloxane linkage, so that hot-melt properties are remarkably improved.

In the above (1) and (2), as the alkylene group contained in component (A₂), an alkenyl group having 2 to 20 carbon atoms such as an ethylene group, a propylene group, a butylene group, a pentylene group, a hexylene group, or the like is exemplified, and these groups may be linear or branched, and are preferably an ethylene group or a hexylene group.

The crosslinked products of resinous organopolysiloxanes and chain organopolysiloxanes, including linear or branched chain organopolysiloxanes, are composed of, for example, the following siloxane units and siloxane units containing silalkylene groups:
M-units: siloxane units represented by R¹R²₂SiO_{1/2};
D-units: siloxane units represented by R¹R²SiO_{2/2};
R³M/R³D-units: at least one siloxane unit selected from a silalkylene group containing siloxane unit represented by R³_{1/2}R²₂SiO_{1/2} and a silalkylene group containing siloxane unit represented by R³_{1/2}R²SiO_{2/2}; and
T/Q-units: at least one siloxane unit selected from a siloxane unit represented by R²SiO_{3/2} and a siloxane unit represented by SiO_{4/2}.

In the formula, each R¹ is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, and the same groups as described above are exemplified. R¹ is preferably a methyl group, a vinyl group, or a phenyl group. However, it is preferable that at least two R¹ of all siloxane units are alkenyl groups.

In addition, in the formula, each R² is independently an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, or an aralkyl group having 7 to 20 carbon atoms, and the same groups as R¹ are exemplified. R² is preferably a methyl group or a phenyl group.

In the formulae, R³ is a linear or branched alkylene group having 2 to 20 carbon atoms bonded to a silicon atom in other siloxane units. As the alkylene group, the same groups as described above are exemplified, and an ethylene group and a hexylene group are preferable.

The M-unit is a siloxane unit constituting the terminal of component (A₂), and the D-unit is a siloxane unit constituting a linear polysiloxane structure. Note that it is preferable that an alkenyl group is present on the M-unit or the D-unit, in particular, the M-unit. On the other hand, the R³M-unit and the R³D-unit are siloxane units bonded to a silicon atom in another siloxane unit via a silalkylene linkage and bonded to a silicon atom in another siloxane unit via an oxygen atom. The T/Q-unit is a branched siloxane unit which gives a resinous structure to the polysiloxane, and component (A₂) preferably contains a siloxane unit represented by R²SiO_{3/2} and/or a siloxane unit represented by SiO_{4/2}. In particular, since the hot-melt properties of component (A₂) is improved and the content of the aryl group in component (A₂) is adjusted, it is preferable that component (A₂) contains a siloxane unit represented by R²SiO_{3/2}, and in particular, it is preferable that component (A₂) contains a siloxane unit in which R² is a phenyl group.

The R³M/R³D-unit is one of the characteristic structures of component (A₂), and represents a structure in which silicon atoms are crosslinked via the alkylene group of R³. Specifically, the R³M/R³D-unit is at least one siloxane unit selected from an alkylene group-containing siloxane unit represented by R³_{1/2}R²₂SiO_{1/2} and an alkylene group-containing siloxane unit represented by R³_{1/2}R²SiO_{2/2}, and at least two of all siloxane units constituting component (A₂) are preferably these alkylene group-containing siloxane units. The preferred form of linkage between siloxane units having alkylene groups of R³ is as described above, and the number of R³ between two alkylene group-containing siloxane units is expressed as the linkage number "1/2" as is the number of oxygens and the like in the M-units. Assuming that the number of R³ is 1, at least one selected from the structural units of siloxanes represented by [O_{1/2}R²₂SiR³SiR²₂O_{1/2}], [O_{1/2}R²₂SiR³SiR²O_{2/2}], and [O_{2/2}R²SiR³SiR²O_{2/2}] is contained in component (A₂), and each oxygen atom (O) is bonded to a silicon atom contained in the M, D, and T/Q-units. With such a structure, component (A₂) can relatively easily design a structure having a chain polysiloxane structure comprised of D-units and a resinous polysiloxane structure containing T/Q-units in the molecule, and the component is remarkably excellent in physical properties.

In the above (1), the component can be obtained by hydrosilylation reaction of an organopolysiloxane having at least two alkenyl groups in one molecule and an organopolysiloxane having at least two silicon atom bonded hydrogen atoms in one molecule at a reaction ratio of [number of moles of alkenyl groups]/[number of moles of silicon atom bonded hydrogen atoms]>1.

In the above (2), the component can be obtained by radical reaction of at least two organopolysiloxanes having at least two radical reactive groups in one molecule with an organic peroxide in an amount which is insufficient for all radical reactive groups in the system to react.

In the above (1) and (2), component (A₂) is obtained by subjecting an organopolysiloxane having a resinous siloxane structure and an organopolysiloxane having a chain siloxane structure to a hydrosilylation reaction or a radical reaction.

For example, component (A₂) is an organopolysiloxane obtained by reacting component (A^{R}) and component (A^{L}) at a ratio designed so that a hydrosilylation reactive group and/or a radical reactive group in component (A^{R}) or component (A^{L}) remains after the reaction, wherein component (A^{R}) is at least one resinous organopolysiloxane that contains a siloxane unit represented by formula R²SiO_{3/2} (wherein R² is the same group as defined above) and/or SiO_{4/2} and has an alkenyl group of 2 to 20 carbon atoms or a silicon bonded hydrogen atom or a radical reactive group, and component (A^{L}) is at least one chain organopolysiloxane that contains a siloxane unit represented by R²₂SiO_{2/2} in the molecule (wherein R² is the same group as defined above) and has an alkenyl group of 2 to 20 carbon atoms or a silicon atom bonded hydrogen atom, which is a group capable of hydrosilylation reaction or radical reaction with the component (A^{R}).

In the above (1), when at least a part of component (A^{R}) is a resinous organopolysiloxane having an alkenyl group of 2 to 20 carbon atoms, it is preferable that at least a part of component (A^{L}) is a chain organopolysiloxane having a silicon atom bonded hydrogen atom.

Similarly, when at least a part of component (A^{R}) is a resinous organopolysiloxane having a silicon atom bonded hydrogen atom, it is preferable that at least a part of component (A^{L}) is a chain organopolysiloxane having an alkenyl group of 2 to 20 carbon atoms.

Such component (A₂) is preferably one obtained by radical reaction of component (a₁): an organopolysiloxane comprised of the following component (a₁₋₁) and/or the following component (a₁₋₂) and having at least two alkenyl groups of 2 to 20 carbon atoms, or one obtained by hydrosilylation reaction of component (a₁) with (a₂) organohydrogenpolysiloxane in the presence of a hydrosilylation reaction catalyst in an amount such that the molar ratio of the silicon atom bonded hydrogen atoms in the component (a₂) to the alkenyl groups having 2 to 20 carbon atoms contained in the component (a₁) is from 0.2 to 0.7 mol.

Component (a₁₋₁) is polysiloxanes with relatively large amounts of branching units, and organopolysiloxanes having at least two alkenyl groups in one molecule, expressed by the average unit formula:

(R⁴₃SiO_{1/2})ₐ(R⁴₂SiO_{2/2})_{b}(R⁴SiO_{3/2})_{c}(SiO_{4/2})_{d}(R⁵O_{1/2})ₑ.

In the formula, each R⁴ is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, and the same groups as the R¹ are exemplified. Preferably, R⁴ is a methyl group, a vinyl group, or a phenyl group. Note that at least two of R⁴ are alkenyl groups. In addition, since the hot-melt properties are good, it is preferable that 10 mol% or more, or 20 mol% or more of the total R4 is a phenyl group. Furthermore, in the formula, R⁵ is a hydrogen atom or an alkyl group having 1 to 6 carbon atoms, and the same alkyl groups as those described above are exemplified.

In the formula, a is a number within the range of 0 to 0.7, b is a number within the range of 0 to 0.7, c is a number within the range of 0 to 0.9, d is a number within the range of 0 to 0.7, e is a number within the range of 0 to 0.1, and c+d is a number within the range of 0.3 to 0.9, a+b+c+d is 1, preferably a is a number within the range of 0 to 0.6, b is a number within the range of 0 to 0.6, c is a number within the range of 0 to 0.9, d is a number within the range of 0 to 0.5, e is a number within the range of 0 to 0.05, and c+d is a number within the range of 0.4 to 0.9, a+b+c+d is 1. This is because the hardness and mechanical strength of the obtained cured product are excellent when a, b, and c+d are each a number within the above range.

As component (a₁₋₁), the following organopolysiloxanes are exemplified. In the formulas, Me, Ph, and Vi represent a methyl group, a phenyl group, and a vinyl group, respectively.
(ViMe₂SiO_{1/2})_{0.25}(PhSiO_{3/2})_{0.75}(HO_{1/2})_{0.02}
(ViMe₂SiO_{1/2})_{0.25}(PhSiO_{3/2})_{0.75}
(ViMe₂SiO_{1/2})_{0.20}(PhSiO_{3/2})_{0.80}
(ViMe₂SiO_{1/2})_{0.15}(Me₃SiO_{1/2})_{0.38}(SiO_{4/2})_{0.47}(HO_{1/2})_{0.01}
(ViMe₂SiO_{1/2})_{0.13}(Me₃SiO_{1/2})_{0.45}(SiO_{4/2})_{0.42}(HO_{1/2})_{0.01}
(ViMe₂SiO_{1/2})_{0.15}(PhSiO_{3/2})_{0.85}(HO_{1/2})_{0.01}
(Me₂SiO_{2/2})_{0.15}(MeViSiO_{2/2})_{0.10}(PhSiO_{3/2})_{0.75}(HO_{1/2})_{0.04}
(MeViPhSiO_{1/2})_{0.20}(PhSiO_{3/2})_{0.80}(HO_{1/2})_{0.05}
(ViMe₂SiO_{1/2})_{0.15}(PhSiO_{3/2})_{0.75}(SiO_{4/2})_{0.10}(HO_{1/2})_{0.02}
(Ph₂SiO_{2/2})_{0.25}(MeViSiO_{2/2})_{0.30}(PhSiO_{3/2})_{0.45}(HO_{1/2})_{0.04}
(Me₃SiO_{1/2})_{0.20}(ViMePhSiO_{1/2})_{0.40}(SiO_{4/2})_{0.40}(HO_{1/2})_{0.08}

Component (a₁₋₂) is polysiloxanes with relatively large amounts of chain siloxane units, and organopolysiloxanes having at least two alkenyl groups in one molecule, expressed by the average unit formula:

(R⁴₃SiO_{1/2})_{a'}(R⁴₂SiO_{2/2})_{b'}(R⁴SiO_{3/2})_{c'}(SiO_{4/2})_{d'}(R⁵O_{1/2})_{e'}.

In the formula, R⁴ and R⁵ are the same groups as described above.

In the formula, a' is a number within the range of 0.01 to 0.3, b' is a number within the range of 0.4 to 0.99, c' is a number within the range of 0 to 0.2, d' is a number within the range of 0 to 0.2, e' is a number within the range of 0 to 0.1, and c'+d' is a number within the range of 0 to 0.2, a'+b'+c'+d' is 1, preferably a' is a number within the range of 0.02 to 0.20, b' is a number within the range of 0.6 to 0.99, c' is a number within the range of 0 to 0.1, d' is a number within the range of 0 to 0.1, j' is a number within the range of 0 to 0.05, and c'+d' is a number within the range of 0 to 0.1, a'+b'+c'+d' is 1. This is because if a', b', c', and d' are each a number within the above range, the obtained cured product can be imparted with toughness.

As component (a₁₋₂), the following organopolysiloxanes are exemplified. In the formulas, Me, Ph, and Vi represent a methyl group, a phenyl group, and a vinyl group, respectively.
ViMe₂SiO(MePhSiO)₁₈SiMe₂Vi, i.e., (ViMe₂SiO_{1/2})_{0.10}(MePhSiO_{2/2})_{0.90}
ViMe₂SiO(MePhSiO)₃₀SiMe₂Vi, i.e., (ViMe₂SiO_{1/2})_{0.063}(MePhSiO_{2/2})_{0.937}
ViMe₂SiO(MePhSiO)₁₅₀SiMe₂Vi, i.e., (ViMe₂SiO_{1/2})_{0.013}(MePhSiO_{2/2})_{0.987}
ViMe₂SiO(Me₂SiO)₁₈SiMe₂Vi, i.e., (ViMe₂SiO_{1/2})_{0.10}(Me₂SiO_{2/2})_{0.90}
ViMe₂SiO(Me₂SiO)₃₀SiMe₂Vi, i.e., (ViMe₂SiO_{1/2})_{0.063}(Me₂SiO_{2/2})_{0.937}
ViMe₂SiO(Me₂SiO)₃₅(MePhSiO)₁₃SiMe₂Vi, i.e.,
(ViMe₂SiO_{1/2})_{0.04}(Me₂SiO_{2/2})_{0.70}(MePhSiO_{2/2})_{0.26}
ViMe₂SiO(Me₂SiO)₁₀SiMe₂Vi, i.e., (ViMe₂SiO_{1/2})_{0.17}(Me₂SiO_{2/2})_{0.83}
(ViMe₂SiO_{1/2})_{0.10}(MePhSiO_{2/2})_{0.80}(PhSiO_{3/2})_{0.10}(HO_{1/2})_{0.02}
(ViMe₂SiO_{1/2})_{0.20}(MePhSiO_{2/2})_{0.70}(SiO_{4/2})_{0.10}(HO_{1/2})_{0.01}
HOMe₂SiO(MeViSiO)₂₀SiMe₂OH
Me₂ViSiO(MePhSiO)₃₀SiMe₂Vi
Me₂ViSiO(Me₂SiO)₁₅₀SiMe2Vi

Component (a₁₋₁) is preferably used from the viewpoint of imparting hardness and mechanical strength to the obtained cured product. Component (a₁₋₂) can be added as an optional component from the viewpoint of imparting toughness to the obtained cured product, but when a crosslinking agent having many chained siloxane units is used in the following component (a₂), it may be used instead. In any case, it is preferable that the mass ratio of the component having a large number of branched siloxane units to the component having a large number of chained siloxane units is within the range of 50:50 to 100:0, or within the range of 60:40 to 100:0. This is because the hardness and mechanical strength of the obtained cured product are good when the mass ratio of the component having a large number of branched siloxane units to the component having a large number of chained siloxane units is within the above range.

When component (a₁) is radically reacted by an organic peroxide, component (a₁₋₁) and component (a₁₋₂) may be reacted within the range of 10:90 to 90:10, and component (a₂) may not be used.

Component (a₂) is a component for crosslinking component (a₁₋₁) and/or component (a₁₋₂) in the hydrosilylation reaction, and is an organopolysiloxane containing at least two silicon atom bonded hydrogen atoms in one molecule. As a group bonded to a silicon atom other than a hydrogen atom in component (a₂), an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, an aralkyl group having 7 to 20 carbon atoms, an alkoxy group, an epoxy group-containing group, or a hydroxyl group is exemplified, and the same groups as those described above are exemplified.

Such component (a₂) is not limited, but preferably is an organohydrogenpolysiloxane, represented by the average composition formula:

R⁶ₖHₘSiO_{(4-k-m)/2}.

In the formulae, R⁶ is an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, or an aralkyl group having 7 to 20 carbon atoms, and the same groups as the above R¹ are exemplified, and preferably a methyl group or a phenyl group.

In the formula, k is a number in the range of 1.0 to 2.5, preferably in the range of 1.2 to 2.3, m is a number in the range of 0.01 to 0.9, preferably in the range of 0.05 to 0.8, and k+m is a number in the range of 1.5 to 3.0, preferably in the range of 2.0 to 2.7.

Component (a₂) may be a resinous organohydrogenpolysiloxane having a large number of branched siloxane units, or the component may be a chained organohydrogenpolysiloxane having a large number of chained siloxane units. Specifically, examples of component (a₂) include an organohydrogenpolysiloxane represented by the following (a₂₋₁), an organohydrogenpolysiloxane represented by the following (a₂₋₂), or mixtures thereof.

Component (a₂₋₁) is a resinous organohydrogenpolysiloxane having a silicon atom bonded hydrogen atom, expressed by the average unit formula:

[R⁷₃SiO_{1/2}]_{f}[R⁷₂SiO_{2/2}]_{g}[R⁷SiO_{3/2}]ₕ[SiO_{4/2}]ᵢ(R⁵O_{1/2})ⱼ.

In the formula, each R⁷ is independently an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, an aralkyl group having 7 to 20 carbon atoms, or a hydrogen atom, and the same groups as the above R¹ are exemplified. Furthermore, in the formula, R⁵ represents a hydrogen atom or an alkyl group having 1 to 6 carbon atoms, and the same groups as described above are exemplified.

In the formula, f is a number within the range of 0 to 0.7, g is a number within the range of 0 to 0.7, h is a number within the range of 0 to 0.9, i is a number within the range of 0 to 0.7, j is a number within the range of 0 to 0.1, and h+i is a number within the range of 0.3 to 0.9, f+g+h+i is 1, preferably f is a number within the range of 0 to 0.6, g is a number within the range of 0 to 0.6, h is a number within the range of 0 to 0.9, i is a number within the range of 0 to 0.5, j is a number within the range of 0 to 0.05, and h+i is a number within the range of 0.4 to 0.9, f+g+h+i+i is 1.

Component (a₂₋₂) is an organopolysiloxane having at least two silicon atom bonded hydrogen atoms in one molecule, expressed by the average unit formula:

(R⁷₃SiO_{1/2})_{f'}(R⁷₂SiO_{2/2})_{g'}(R⁷SiO_{3/2})_{h'}(SiO_{4/2})_{i'}(R⁵O_{1/2})_{j'}.

In the formula, R⁷ and R⁵ are the same groups as described above.

In the formula, f is a number within the range of 0.01 to 0.3, g' is a number within the range of 0.4 to 0.99, h' is a number within the range of 0 to 0.2, i' is a number within the range of 0 to 0.2, j' is a number within the range of 0 to 0.1, and h'+i' is a number within the range of 0 to 0.2, and f'+g'+h'+i' is 1, preferably f' is a number within the range of 0.02 to 0.20, g' is a number within the range of 0.6 to 0.99, h' is a number within the range of 0 to 0.1, i' is a number within the range of 0 to 0.1, j' is a number within the range of 0 to 0.05, and h'+i' is a number within the range of 0 to 0.1, and f'+g'+h'+i' is 1.

As described above, in component (a₂), the resinous organopolysiloxane having many branched siloxane units imparts hardness and mechanical strength to the cured product, and the obtained organopolysiloxane having many chained siloxane units imparts toughness to the cured product, and therefore, it is preferable to appropriately use component (a₂₋₁) and component (a₂₋₂) as component (a₂). Specifically, when the number of branched siloxane units in component (a₁) is small, it is preferable to mainly use component (a₂₋₁) as component (a₂), and when the number of chained siloxane units in component (a₁) is small, it is preferable to mainly use component (a₂₋₂). Component (a₂) preferably has a mass ratio of component (a₂₋₁) to component (a₂₋₂) within the range of 50:50 to 100:0, or within the range of 60:40 to 100:0.

As component (a₂), the following organopolysiloxanes are exemplified. In the formulas, Me and Ph represent a methyl group and a phenyl group, respectively.
Ph2Si(OSiMe2H)2, i.e., Ph_{0.67}Me_{1.33}H_{0.67}SiO_{0.67}
HMe₂SiO(Me₂SiO)₂₀SiMe₂H, i.e., Me_{2.00}H_{0.09}SiO_{0.95}
HMe₂SiO(Me₂SiO)₅₅SiMe₂H, i.e., Me_{2.00}H_{0.04}SiO_{0.98}
PhSi(OSiMe2H)3, i.e., Ph_{0.25}Me_{1.50}H_{0.75}SiO_{0.75}
(HMe₂SiO_{1/2})_{0.6}(PhSiO_{3/2})_{0.4}, i.e., Ph_{0.40}Me_{1.20}H_{0.60}SiO_{0.90}

The amount of component (a₂) to be added is such that the molar ratio of silicon atom bonded hydrogen atoms in component (a₂) to the alkenyl groups in component (a₁) is in an amount of 0.2 to 0.7, preferably in an amount of 0.3 to 0.6. This is because the hardness and the mechanical strength of the obtained cured product are good when the amount of component (a₂) to be added is within the above ranges.

The organic peroxide used for radically reacting component (a₁) is not limited, and the organic peroxides exemplified by component (C) below can be used. In the radical reaction, component (a₁) is preferably a mixture of component (a₁₋₁) and component (a₁₋₂) in the mass ratio ranging from 10:90 to 90:10. Although the amount of the organic peroxide to be added is not limited, it is preferably within the range of 0.1 to 5 parts by mass, within the range of 0.2 to 3 parts by mass, or within the range of 0.2 to 1.5 parts by mass, based on 100 parts by mass of component (a₁).

The hydrosilylation reaction catalyst used for the hydrosilylation reaction of component (a₁) and component (a₂) is not limited, and a hydrosilylation reaction catalyst exemplified by component (C) below can be used. The amount of the hydrosilylation reaction catalyst to be added is preferably an amount in which platinum-based metal atoms in the hydrosilylation reaction catalyst are within the range of 0.01 to 500 ppm, within the range of 0.01 to 100 ppm, or within the range of 0.01 to 50 ppm in terms of mass units, with regard to the total amount of component (a₁) and component (a₂).

The above component (3) is obtained by condensing the following component (a₃) and the following component (a₄) with a condensation reaction catalyst.

Component (a₃) is a condensation reactive organopolysiloxane, expressed by the average unit formula:

(R⁸₃SiO_{1/2})ₚ(R⁸₂SiO_{2/2})_{q}(R⁸SiO_{3/2})ᵣ(SiO_{4/2})ₛ(R⁹O_{1/2})ₜ.

In the formula, each R₈ is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, and the same groups as described above are exemplified. Furthermore, in the formula, R⁹ is a hydrogen atom, an alkyl group having 1 to 6 carbon atoms, or an acyl group having 2 to 5 carbon atoms, and an alkoxy group such as a methoxy group or an ethoxy group and an acyloxy group are exemplified. Component (a₃) has at least one silicon atom bonded hydroxyl group, silicon atom bonded alkoxy group, or silicon atom bonded acyloxy group in one molecule. In addition, it is preferable that in one molecule, at least two R⁸ is an alkenyl group, and 10 mol% or more, or 20 mol% or more of the total R⁸ is a phenyl group.

In the formula, p is a number within the range of 0 to 0.7, q is a number within the range of 0 to 0.7, r is a number within the range of 0 to 0.9, s is a number within the range of 0 to 0.7, t is a number within the range of 0.01 to 0.10, and r+s is a number within the range of 0.3 to 0.9, p+q+r+s is 1, and preferably p is a number within the range of 0 to 0.6, q is a number within the range of 0 to 0.6, r is a number within the range of 0 to 0.9, s is a number within the range of 0 to 0.5, t is a number within the range of 0.01 to 0.05, and r+s is a number within the range of 0.4 to 0.9. This is because, when p, q, and r+s are each a number within the above range, a hot-melt silicone having flexibility at 25°C. but non-fluidity, low surface tack, and sufficiently low melt viscosity at high temperature is obtained.

Component (a₄) is a condensation reactive organopolysiloxane, expressed by the average unit formula:

(R⁸₃SiO_{1/2})_{p'}(R⁸₂SiO_{2/2})_{q'}(R⁸SiO_{3/2})_{r'}(SiO_{4/2})_{s'}(R⁹O_{1/2})_{t'}.

In the formula, R⁸ and R⁹ are the same groups as described above. Component (a₄) has at least one silicon atom bonded hydroxyl group, silicon atom bonded alkoxy group, or silicon atom bonded acyloxy group in one molecule. In the formula, p' is a number within the range of 0.01 to 0.3, q' is a number within the range of 0.4 to 0.99, r' is a number within the range of 0 to 0.2, s' is a number within the range of 0 to 0.2, t' is a number within the range of 0 to 0.1, and r'+s' is a number within the range of 0 to 0.2, p'+q'+r'+s' is 1, and preferably p' is a number within the range of 0.02 to 0.20, q' is a number within the range of 0.6 to 0.99, r' is a number within the range of 0 to 0.1, s' is a number within the range of 0 to 0.1, t' is a number within the range of 0 to 0.05, and r'+s' is a number within the range of 0 to 0.1. This is because, when p', q', r', and s' are each a number within the above range, a hot-melt silicone having flexibility at 25°C. but non-fluidity, low surface tack, and sufficiently low melt viscosity at high temperature is obtained.

The condensation reaction catalyst for condensation reaction of component (a₃) and component (a₄) is not limited, and examples thereof include organic tin compounds such as dibutyltin dilaurate, dibutyltin diacetate, tin octenate, dibutyltin dioctate, and tin laurate; organic titanium compounds such as tetrabutyl titanate, tetrapropyl titanate, and dibutoxy bis(ethyl acetoacetate); acidic compounds such as hydrochloric acid, sulfuric acid, and dodecylbenzene sulfonic acid; alkaline compounds such as ammonia and sodium hydroxide; amine-based compounds such as 1,8-diazabicyclo[5.4.0]undecene (DBU), 1,4-diazabicyclo[2.2.2]octane (DABCO), and preferably an organic tin compound, and an organic titanium compound.

Component (A₃) is a block copolymer composed of a resinous organosiloxane block and a chained organosiloxane block. Such component (A₃) is preferably comprised of 40 to 90 mol% of disiloxy units of the formula [R¹₂SiO_{2/2}], 10 to 60 mol% of trisiloxy units of the formula [R¹SiO_{3/2}], and preferably contains 0.5 to 35 mol% of silanol groups [=SiOH]. Here, each R¹ is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, and the same groups as described above are exemplified. At least two R¹ in one molecule is an alkenyl group. Further, component (A₃) is a resinous organosiloxane block copolymer in which the disiloxy unit [R¹₂SiO_{2/2}] forms a linear block having on average 100 to 300 disiloxy units per one linear block; the trisiloxy unit [R¹SiO_{3/2}] forms a non-linear block having a molecular weight of at least 500 g/mol; at least 30% of the non-linear blocks are bonded to each other; each linear block is bonded to at least one non-linear block via a -Si-O-Si- linkage; the resinous organosiloxane block copolymer having a mass-average molecular weight of at least 20000 g/mol, and containing at least one alkenyl group of 0.5 to 4.5 mol%.

Component (A₃) is prepared by condensation reaction of (a₅) a resinous organosiloxane or a resinous organosiloxane block copolymer with (a₆) a chained organosiloxane, and optionally (a₇) a siloxane compound.

Component (a₅) is a resinous organopolysiloxane, expressed by the average unit formula:

[R¹₂R²SiO_{1/2}]ᵢ[R¹R²SiO_{2/2}]ᵢᵢ[R¹SiO_{3/2}]ᵢᵢᵢ[R²SiO_{3/2}]ᵢᵥ[SiO_{4/2}]ᵥ.

In the formula, each R₁ is independently an alkyl group having 1 to 20 carbon atoms, a halogen-substituted alkyl group having 1 to 20 carbon atoms, an alkenyl group having 2 to 20 carbon atoms, an aryl group having 6 to 20 carbon atoms, a halogen-substituted aryl group having 6 to 20 carbon atoms, or an aralkyl group having 7 to 20 carbon atoms, and the same groups as described above are exemplified. In addition, in the formula, each R² is independently an alkyl group having 1 to 20 carbon atoms, a halogen-substituted alkyl group having 1 to 20 carbon atoms, an aryl group having 6 to 20 carbon atoms, a halogen-substituted aryl group having 6 to 20 carbon atoms, or an aralkyl group having 7 to 20 carbon atoms, and the same groups as the R¹ are exemplified.

Also, in the formula, i, ii, iii, iv, and v represent the mole fraction of each siloxy unit, i is a number from 0 to 0.6, ii is a number from 0 to 0.6, iii is a number from 0 to 1, iv is a number from 0 to 1, and v is a number from 0 to 0.6, with the proviso that (ii+iii+iv+v) > 0 and (i+ii+iii+iv+v) ≦ 1. In addition, component (a₅) preferably contains 0 to 35 mol% of a silanol group [=SiOH] in one molecule.

Component (a₆) is a linear organosiloxane expressed by general formula:

R¹_{3-α}(X)_{α}SiO(R¹₂SiO)_{β}Si(X)_{α}R¹_{3-α}.

In the formula, R¹ is the same as described above, and the same groups as described above are exemplified. In addition, in the formula, X is a hydrolyzable group selected from -OR⁵, F, CI, Br, I, -OC(O)R⁵, -N(R⁵)₂, or - ON=CR⁵₂, wherein R⁵ is a hydrogen atom or an alkyl group having 1 to 6 carbon atoms. Furthermore, in the formula, α is independently 1, 2, or 3, and β is an integer of 50 to 300.

Component (a₇) is a siloxane compound expressed by general formula:

R¹R²₂SiX.

In the formula, R¹, R², and X are the same groups as described above.

The condensation reaction catalyst for condensation reaction of component (a₅) and component (a₆) and/or component (a₇) is not limited, and examples thereof include organic tin compounds such as dibutyltin dilaurate, dibutyltin diacetate, tin octenate, dibutyltin dioctate, and tin laurate; organic titanium compounds such as tetrabutyl titanate, tetrapropyl titanate, and dibutoxy bis(ethyl acetoacetate); acidic compounds such as hydrochloric acid, sulfuric acid, and dodecylbenzene sulfonic acid; alkaline compounds such as ammonia and sodium hydroxide; amine-based compounds such as 1,8-diazabicyclo[5.4.0]undecene (DBU), 1,4-diazabicyclo[2.2.2]octane (DABCO).

Component (A) preferably exhibits hot-melt properties, in particular is non-fluid at 25°C. and preferably has a melt viscosity of less than or equal to 8000 Pa·s at 100°C. Non-fluid refers to not flowing in a no-load condition, for example, the state of being lower than the softening point measured by the softening point testing method in the ball and ring method of hot melt adhesives specified in "Testing methods for the softening point of hot melt adhesives" of JIS K 6863-1994. That is, in order to be non-fluid at 25°C., the softening point must be higher than 25°C.

Component (A) preferably has a melt viscosity at 100°C. of 8000 Pa·s or less, 5000 Pa·s or less, or within the range of 10 to 3000 Pa·s. Moreover, when the melt viscosity at 100°C. is within the abovementioned range, favorable adhesiveness after being hot melted and then cooled at 25°C. is obtained.

As long as component (A) is in the form of fine particles, the particle diameter is not limited, but the average primary particle diameter is preferably within the range of 1 to 5000 µm, within the range of 1 to 500 µm, within the range of 1 to 100 µm, within the range of 1 to 20 µm, or within the range of 1 to 10 µm. The average primary particle diameter can be obtained, for example, by observation with an optical microscope or an SEM. The shape of component (A) is not limited, and a spherical shape, a spindle shape, a plate shape, a needle shape, and an irregular shape are exemplified, and it is preferable to have a spherical shape or a true spherical shape because it melts uniformly. In particular, by setting component (A) to have a true spherical shape of 1 to 10 µm, it is possible to improve the melting characteristics of the present composition and further to reduce the average linear expansion coefficient after curing.

The method for producing component (A) is not limited, and a known method can be used. For example, component (A) is simply atomized, or at least two kinds of organopolysiloxanes are crosslinked and the reactants are atomized simultaneously or separately.

As a method for finely-pulverizing the obtained silicone after crosslinking at least two kinds of organopolysiloxanes, for example, a method of pulverizing the silicone using a pulverizer or a method of directly pulverizing the silicone in the presence of a solvent can be cited. The pulverizer may be, for example, but not limited to, a roll mill, a ball mill, a jet mill, a turbo mill, or a planetary mill. As a method of directly atomizing the silicone in the presence of a solvent, for example, spraying by a spray dryer, or atomization by a biaxial kneader or a belt dryer can be cited. In the present invention, it is particularly preferable to use true-spherical hot-melt silicone fine particles obtained by spraying with a spray dryer from the viewpoints of melting characteristics of the hard granular compound, the average linear expansion coefficient of the cured product, efficiency in manufacturing and handling workability of the composition.

By using a spray dryer or the like, component (A) having a true spherical shape and an average primary particle diameter of 1 to 10 µm can be produced. The heating and drying temperature of the spray dryer needs to be appropriately set based on the heat resistance of the silicone fine particles and the like. In order to prevent secondary aggregation of the silicone fine particles, it is preferable to control the temperature of the silicone fine particles to be equal to or lower than the glass transition temperature thereof. The silicone fine particles thus obtained can be recovered by a cyclone, a bag filter, or the like.

In order to obtain a uniform component (A), a solvent may be used in the above-mentioned step within the range that does not inhibit the curing reaction. Examples of the solvents include, but are not limited to, aliphatic hydrocarbons such as n-hexane, cyclohexane, and n-heptane; aromatic hydrocarbons such as toluene, xylene, and mesitylene; ethers such as tetrahydrofuran and dipropyl ether; silicones such as hexamethyldisiloxane, octamethyltrisiloxane, and decamethyltetrasiloxane; esters such as ethyl acetate, butyl acetate, and propylene glycol monomethyl ether; and ketones such as acetone, methyl ethyl ketone, and methyl isobutyl ketone.

Component (B) of the present invention is an inorganic filler and it is possible to provide a curable particulate silicone composition which cures to give a cured product excellent in hardness and toughness from room temperature to high temperature.

Such component (B) is preferably at least one filler which does not have a softening point or does not soften below the softening point of the component (A), and may be a component which improves the handling workability of the composition and imparts mechanical properties and other properties to the cured product of the composition. Examples of component (B) include inorganic fillers, organic fillers, and mixtures thereof, and inorganic fillers are preferable. As the inorganic filler, a reinforcing filler, a white pigment, a thermally conductive filler, a conductive filler, a phosphor, and a mixture of at least two of these are exemplified, and in particular, it is preferable to contain a reinforcing filler having an average particle diameter of 10.0 µm or more. Examples of the organic filler include a silicone resin filler, a fluorine resin filler, and a polybutadiene resin filler. The shape of these fillers is not particularly limited, and may be spherical, spindle-shaped, flat, needle-shaped, amorphous, or the like.

Component (B) is preferably an inorganic filler having an average particle diameter of 10.0 µm or more, and in particular, since the hardness at room temperature to high temperature and the rate of change in storage modulus are small, it is particularly preferable that component (B) is a spherical inorganic filler having an average particle diameter of 10.0 µm or more. In addition, by using an inorganic filler larger than the particle diameter of component (A), the inorganic filler can form good packing at the time of melting, so that it is possible to greatly reduce the average linear expansion coefficient. Such an inorganic filler can be blended or filled in a relatively large amount with respect to component (A), and there is a practical advantage that the mechanical strength of the cured product can be further improved. On the other hand, it is possible and preferable to blend an inorganic filler or an organic filler having an average particle diameter of 5 µm or less for the purpose of imparting or improving the light reflection property, conductivity, thermal conductivity, fluorescent property, stress relaxation property, etc. of the composition of the present invention.

When the present composition is used for applications such as sealants, protective agents, adhesives, light reflecting materials, etc., since it imparts mechanical strength to the cured product and improves the protective property or adhesiveness, it is preferable to incorporate a reinforcing filler as component (B). Examples of the reinforcing filler include fumed silica, precipitated silica, fused silica, calcined silica, fumed titanium dioxide, quartz, calcium carbonate, diatomaceous earth, aluminum oxide, aluminum hydroxide, zinc oxide, and zinc carbonate. These reinforcing fillers may also be surface treated with organoalkoxysilanes such as methyltrimethoxysilane; organohalosilanes such as trimethylchlorosilane; organosilazanes such as hexamethyldisilazane; siloxane oligomers such as α,ω-silanol group- blocked dimethylsiloxane oligomers, α,ω-silanol group-blocked methylphenylsiloxane oligomers, α,ω-silanol group-blocked methylvinylsiloxane oligomers, and the like. Further, as the reinforcing filler, a fibrous filler such as calcium metasilicate, potassium titanate, magnesium sulfate, sepiolite, zonolite, aluminum borate, rock wool, glass fiber, or the like may be used.

In particular, from the viewpoint of imparting the hardness of the cured product at room temperature to high temperature, component (B) is preferably spherical silica or aluminum oxide (alumina) having an average particle diameter of 10.0 µm or more.

Component (B) may contain silicone fine particles which do not correspond to component (A), and the stress relaxation characteristics and the like can be improved or adjusted as desired. Silicone fine particles include non-reactive silicone resin fine particles and silicone elastomer fine particles, but silicone elastomer fine particles are suitably exemplified from the standpoint of improving flexibility or stress relaxation properties.

The silicone elastomer fine particles are a crosslinked product of linear diorganopolysiloxane comprised of primarily of diorganosiloxy units (D-units). The silicone elastomer fine particles can be prepared by a crosslinking reaction of diorganopolysiloxane by a hydrosilylation reaction, a condensation reaction of a silanol group, or the like, and in particular, the silicone elastomer fine particles can be suitably obtained by a crosslinking reaction of organohydrogenpolysiloxane having a silicon bonded hydrogen atom at a side chain or a terminal with diorganopolysiloxane having an unsaturated hydrocarbon group such as an alkenyl group at a side chain or a terminal under a hydrosilylation reaction catalyst. The silicone elastomer fine particles may have various shapes such as spherical, flat, and irregular shapes, but are preferably spherical in terms of dispersibility, and among these, true spherical is more preferable. Commercial products of such silicone elastomer fine particles include, for example, "Torefil-E series" and "EP Powder series" manufactured by Dow Corning Toray Company, Ltd., and "KMP series" manufactured by Shin-Etsu Chemical Co., Ltd. The silicone elastomer fine particles may be subjected to a surface treatment. Examples of the surface treatment agent include, for example, methylhydrogenpolysiloxane, silicone resin, metal soap, silane coupling agent, inorganic oxide such as silica and titanium oxide, fluorine compound such as perfluoroalkylsilane and perfluoroalkylphosphate ester salt.

When the present composition is used as a wavelength conversion material for an LED, a phosphor may be blended as component (B) to convert the emission wavelength from the optical semiconductor element. There is no particular limitation on this phosphor, and examples of the phosphor include yellow, red, green, and blue light phosphors, which include oxide phosphors, oxynitride phosphors, nitride phosphors, sulfide phosphors, oxysulfide phosphors, and the like, which are widely used in light emitting diodes (LED). Examples of the oxide phosphors include yttrium, aluminum, and garnet-type YAG green to yellow light phosphors containing cerium ions; terbium, aluminum, and garnet-type TAG yellow light phosphors containing cerium ions; and silicate green to yellow light phosphors containing cerium or europium ions. In addition, exemplary oxynitride phosphors include silicon, aluminum, oxygen, and nitrogen type SiAION red to green light phosphors containing europium ions. Examples of nitride phosphors include calcium, strontium, aluminum, silicon, and nitrogen-type CASN red light phosphors containing europium ions. Exemplary sulfide phosphors include ZnS green light phosphors containing copper ions or aluminum ions. Exemplary oxysulfide phosphors include Y₂O₂S red light phosphors containing europium ions. In the composition, two or more of these phosphors may be used in combination.

In addition, the composition may contain a thermally conductive filler or a conductive filler to impart thermal or electrical conductivity to the cured product. As the thermally conductive filler or the conductive filler, there are exemplified a metal fine powder such as gold, silver, nickel, copper, aluminum; a fine powder obtained by depositing or plating a metal such as gold, silver, nickel, copper or the like on the surface of a fine powder such as ceramic, glass, quartz, organic resin or the like; a metal compound such as aluminum oxide, magnesium oxide, aluminum nitride, boron nitride, zinc oxide or the like; graphite, and a mixture of two or more of these. When electrical insulation is required for the present composition, a metal oxide-based powder or a metal nitride-based powder is preferable, and in particular, an aluminum oxide powder, a zinc oxide powder, or an aluminum nitride powder is preferable.

The content of component (B) is preferably within the range of 100 to 4000 parts by mass, within the range of 250 to 4000 parts by mass, or within the range of 500 to 4000 parts by mass, with regard to 100 parts by mass of component (A). In particular, component (B) of the present invention preferably contains an inorganic filler having an average particle diameter of 10.0 µm or more, particularly a spherical inorganic filler, and even if it is blended in a relatively large amount relative to component (A), the handling workability of the composition does not deteriorate and the obtained cured product has excellent average linear expansion coefficient and mechanical strength at room temperature to high temperature, and therefore in the composition of the present invention, it is preferable that 80 mass% or more, 85 mass% or more and 90 mass% of the whole is the above-mentioned component (B).

Component (C) is a curing agent for curing component (A), and is not limited as long as component (A) can be cured. When component (A) has an alkenyl group, component (C) is an organohydrogenpolysiloxane having at least two silicon atom bonded hydrogen atoms in one molecule and a hydrosilylation reaction catalyst, when component (A) contains an alkenyl group and contains a hydrosilylation reaction catalyst, component (C) may be only an organopolysiloxane having at least two silicon atom bonded hydrogen atoms in one molecule, but a hydrosilylation reaction catalyst may be used in combination. In addition, when component (A) has an alkenyl group, component (C) may be an organic peroxide, but an organopolysiloxane having at least two silicon atom bonded hydrogen atoms may be used in combination in one molecule. On the other hand, when component (A) has a silicon atom bonded hydrogen atom, component (C) is an organopolysiloxane having at least two alkenyl groups in one molecule and a hydrosilylation reaction catalyst, when component (A) has a silicon atom bonded hydrogen atom and contains a hydrosilylation reaction catalyst, component (C) may be an organopolysiloxane having at least two alkenyl groups in one molecule, but a hydrosilylation reaction catalyst may be used in combination.

Examples of organopolysiloxanes in component (C) include organopolysiloxanes containing alkenyl groups represented by the above (a₁) and/or the above (a₂), or organopolysiloxanes containing silicon atom bonded hydrogen atoms represented by the above (a₃) and/or the above (a₄).

When an organopolysiloxane is used as component (C), the content thereof is not limited, but for curing the composition, it is preferable that the amount of silicon atom bonded hydrogen atoms is within the range of 0.5 to 20 mol or within the range of 1.0 to 10 mol with regard to 1 mol of alkenyl group in the composition.

As the hydrosilylation reaction catalyst, platinum-based catalysts, rhodium-based catalysts, and palladium-based catalysts are exemplified, and platinum-based catalysts are preferable because the curing of the present composition can be remarkably accelerated. Examples of the platinum-based catalyst include platinum fine powder, chloroplatinic acid, an alcohol solution of chloroplatinic acid, a platinum-alkenyl siloxane complex, a platinum-olefin complex, a platinum-carbonyl complex, and a catalyst in which a platinum-based catalyst is dispersed or encapsulated with a thermoplastic resin such as silicone resin, polycarbonate resin, acrylic resin or the like, with a platinum-alkenyl siloxane complex particularly preferable. Examples of this alkenyl siloxane include: 1,3-divinyl-1,1,3,3-tetramethyldisiloxane; 1,3,5,7-tetramethyl-1,3,5,7-tetravinylcyclotetrasiloxane; an alkenyl siloxane obtained by substituting part of methyl groups of these alkenyl siloxanes with an ethyl group, a phenyl group, etc.; and an alkenyl siloxane obtained by substituting part of vinyl groups of these alkenyl siloxanes with an allyl group, a hexenyl group, etc. In particular, 1,3-divinyl-1,1,3,3-tetramethyldisiloxane is preferable because the platinum-alkenylsiloxane complex has good stability. In addition, a particulate platinum-containing hydrosilylation reaction catalyst dispersed or encapsulated with a thermoplastic resin may be used from the standpoint of improving handling workability and pot life of the composition. As the catalyst for promoting the hydrosilylation reaction, a non-platinum metal catalyst such as iron, ruthenium, iron/cobalt, or the like may be used.

The amount of the hydrosilylation reaction catalyst to be added is preferably an amount in which the metal atom is within the range of 0.01 to 500 ppm, an amount within the range of 0.01 to 100 ppm, or an amount within the range of 0.01 to 50 ppm in terms of mass units with regard to component (A).

Examples of organic peroxide include alkyl peroxides, diacyl peroxides, ester peroxides, and carbonate peroxides.

Examples of alkyl peroxides include dicumyl peroxide, di-tert-butyl peroxide, di-tert-butylcumyl peroxide, 2,5-dimethyl-2,5-di(tert-butylperoxy)hexane, 2,5-dimethyl-2,5-di(tert-butylperoxy)hexyne-3, tert-butylcumyl, 1,3-bis(tert-butylperoxyisopropyl)benzene, and 3,6,9-triethyl-3,6,9-trimethyl-1,4,7-triperoxonan.

Examples of diacyl peroxides include benzoyl peroxide, lauroyl peroxide, and decanoyl peroxide.

Examples of ester peroxides include 1,1,3,3-tetramethylbutylperoxyneodecanoate, α-cumylperoxyneodecanoate, tert-butylperoxyneodecanoate, tert-butylperoxyneoheptanoate, tert-butylperoxypivalate, tert-hexylperoxypivalate, 1,1,3,3-tetramethylbutylperoxy-2-ethylhexanoate, tert-amylperoxyl-2-ethylhexanoate, tert-butylperoxy-2-ethylhexanoate, tert-butylperoxyisobutyrate, di-tert-butylperoxyhexahydroterephthalate, tert-amylperoxy-3,5,5-trimethylhexanoate, tert-butylperoxy-3,5,5-trimethylhexanoate, tert-butylperoxyacetate, tert-butylperoxybenzoate, and dibutylperoxytrimethyladipate.

Examples of carbonate peroxides include di-3-methoxybutyl peroxydicarbonate, di(2-ethylhexyl)peroxydicarbonate, diisopropyl peroxycarbonate, tert-butyl peroxyisopropylcarbonate, di(4-tert-butylcyclohexyl)peroxydicarbonate, dicetyl peroxydicarbonate, and dimyristyl peroxydicarbonate.

The organic peroxide preferably has a 10-hour half-life temperature of 90°C. or more, or 95°C. or more. Examples of such organic peroxide include dicumyl peroxide, di-tert-butyl peroxide, di-tert-hexyl peroxide, tert-butylcumyl peroxide, 2,5-dimethyl-2,5-di(tert-butylperoxy)hexane, 1,3-bis(tert-butylperoxyisopropyl)benzene, di-(2-tert-butylperoxyisopropyl)benzene, and 3,6,9-triethyl-3,6,9-trimethyl-1,4,7-triperoxonan.

While not limited thereto, the content of organic peroxide is preferably within the range of 0.05 to 10 parts by mass, or within the range of 0.10 to 5.0 parts by mass, with regard to 100 parts by mass of component (A).

The present composition may contain a curing retardant or an adhesion imparting agent as other optional components as long as the object of the present invention is not impaired.

Examples of the curing retardant include: alkyne alcohols such as 2-methyl-3-butyne-2-ol, 3,5-dimethyl-1-hexyne-3-ol, 2-phenyl-3-butyne-2-ol, 1-ethynyl-1-cychlohexanol; enyne compounds such as 3-methyl-3-pentene-1-yne, 3,5-dimethyl-3-hexene-1-yne; alkenyl group-containing low molecular weight siloxanes such as tetramethyltetravinylcyclotetrasiloxane and tetramethyltetrahexenylcyclotetrasiloxane; and alkynyloxysilanes such as methyl tris(1,1-dimethyl propynyloxy)silane and vinyl tris(1,1-dimethyl propynyloxy)silane. The content of the curing retardant is not limited, but is preferably within the range of 10 to 10000 ppm in terms of mass units, with regard to the composition.

As the adhesion imparting agent, an organosilicon compound having at least one alkoxy group bonded to a silicon atom in one molecule is preferable. Examples of this alkoxy group include a methoxy group, an ethoxy group, a propoxy group, a butoxy group, and a methoxyethoxy group, with a methoxy group particularly preferable. Moreover, examples of groups other than alkoxy group, bonded to the silicon atom of the organosilicon compound include: halogen substituted or unsubstituted monovalent hydrocarbon groups such as an alkyl group, an alkenyl group, an aryl group, an aralkyl group, and a halogenated alkyl group; glycidoxyalkyl groups such as a 3-glycidoxypropyl group and a 4-glycidoxybutyl group; epoxycyclohexylalkyl groups such as a 2-(3,4-epoxycyclohexyl)ethyl group and a 3-(3,4-epoxycyclohexyl)propyl group; epoxyalkyl groups such as a 3,4-epoxybutyl group and a 7,8-epoxyoctyl group; acryl group-containing monovalent organic groups such as a 3-methacryloxypropyl group; and hydrogen atoms. This organosilicon compound preferably has a group that may react with an alkenyl group or a silicon atom bonded hydrogen atom in this composition, and specifically, preferably has a silicon atom bonded hydrogen atom or an alkenyl group. Moreover, because favorable adhesion can be imparted to various base materials, this organosilicon compound preferably has at least one epoxy group-containing a monovalent organic group per one molecule. Examples of such an organosilicon compound include an organosilane compound, an organosiloxane oligomer, and an alkyl silicate. Examples of the molecular structure of this organosiloxane oligomer or alkyl silicate include a linear structure, a partially branched linear structure, a branched structure, a cyclic structure, and a network structure, with a linear structure, a branched structure, and a network structure particularly preferable. Examples of an organosilicon compound include: silane compounds such as 3-glycidoxypropyltrimethoxysilane, 2-(3,4-epoxycyclohexyl)ethyltrimethoxysilane, and 3-methacryloxypropyltrimethoxysilane; mixtures of siloxane compounds having at least one silicon bonded alkenyl group or silicon bonded hydrogen atom and at least one silicon bonded alkoxy group, silane compounds or siloxane compounds having at least one silicon atom bonded alkoxy group in one molecule and siloxane compounds having at least one silicon atom bonded hydroxy group and at least one silicon atom bonded alkenyl group in one molecule; methylpolysilicate; ethylpolysilicate; and an epoxy group-containing ethylpolysilicate. The adhesion imparting agent is preferably in the form of a low viscosity liquid, and its viscosity is not limited, but it is preferably within the range of 1 to 500 mPa·s at 25°C. In addition, while not limited thereto, the content of this adhesion imparting agent is preferably within the range of 0.01 to 10 parts by mass with regard to 100 parts by mass of the total of the present composition.

Further, as long as the object of the present invention is not impaired, the present composition may contain, as other optional ingredients, at least one liquid organopolysiloxane of the above (a1) to (a4); a heat-resistant agent such as iron oxide (red iron oxide), cerium oxide, cerium dimethylsilanoate, fatty acid cerium salt, cerium hydroxide, and zirconium compounds; a release agent such as carnauba wax, montan wax, calcium stearate, calcium montanate, magnesium stearate, magnesium montanate, zinc stearate, zinc montanate, ester wax, and olefinic wax; and other agents such as dyes, non-white pigments, flame retardants, and the like.

The cured product formed by curing the above composition provides a cured product that has an average linear expansion coefficient at a temperature range of 25°C. to 200°C. of 30 ppm/°C. or less and the ratio of the value of the storage modulus at -50°C. (G'-₅₀) to the value of the storage modulus at 250°C. (G'250): (G'₋₅₀/G'₂₅₀) is in the range of 1/1 to 1/50.

In recent years, particularly the use of power semiconductors has been rapidly expanding, application is required also in regions and applications where there is a large difference in the temperature compared to the past, but the cured product according to the present invention has a practical advantage in that it can maintain stable physical properties even under such low to high temperature conditions and can protect semiconductor elements and the like.

The low average linear expansion coefficient in the range of 25°C. to 200°C. of the cured product obtained by curing the above composition means that the cured product is hardly deformed at room temperature to high temperature and maintains a constant hardness to some extent. For this reason, the cured product obtained by curing the composition according to the present invention is useful in that it is hard, tough, and changes in hardness are small at both room temperature (25°C.) and high temperature (200°C.), and therefore, it is difficult to cause defects such as breakage, deformation, peeling, and gap (void) during molding including the cooling process. The above composition is particularly suitable for overmold molding applications, and the cured product preferably has an average linear expansion coefficient of 25 ppm/°C. or less in the range of 25°C. to 200°C., and more preferably 20 ppm/°C. or less.

The cured product obtained by curing the above composition is further characterized in that the ratio of the storage modulus at -50°C. (G'-₅₀) to the storage modulus at 250°C. (G'250), (G'₋₅₀/G'₂₅₀), ranges from 1/1 to 1/50. That is, the cured product is useful in that the change of the storage modulus does not greatly change from a low temperature (-50°C.) to a high temperature (250°C.) and the decrease of the storage modulus remains in the range of 1/50 or less, so that the toughness of the cured product does not change from a low temperature to a high temperature, and defects such as breakage, cracking, deformation, peeling, and gap (void) of the cured product due to the temperature change are hardly generated in the cured product after sealing the semiconductor or the circuit element, for example. From the viewpoint of the application and durability of the semiconductor sealant and the like, the cured product preferably has the ratio of the storage modulus at -50°C. (G'₋₅₀) to the storage modulus at 250°C. (G'250), (G'₋₅₀/G'₂₅₀) in the range of 1/5 to 1/45, and particularly preferably in the range of 1/10 to 1/40.

In addition, it is preferable that the cured product obtained by curing the above composition does not have a definite inflection point in the change of the linear expansion coefficient (TMA curve) in the range of 20°C. to 300°C., preferably in the range of 25°C. to 200°C. More preferably, even when the storage modulus changes in the range of -50°C. to 250°C., it is preferable not to have a definite inflection point. By selecting the combination of component (A) and component (B), it is possible to design a composition providing a cured product exhibiting such a behavior of an average linear expansion coefficient and a storage modulus, and the obtained composition is less likely to cause defects such as breakage, cracking, deformation, peeling, and gap (voids) of the cured product during molding or in response to a temperature shock because the change in hardness and softness are constant with respect to temperature. Therefore, even when used as a sealant or a protective material of a power semiconductor device used under severe temperature conditions, initial overmold molding can be stably and efficiently performed, and the semiconductor element and the circuit board can be protected for a long period of time, and deterioration of the semiconductor element and the circuit board can be suppressed to realize a long life.

The present composition may be used in pellet form. The pellets of the present composition are obtained by compression molding the present composition, and are excellent in handling workability and curability. The "pellet" may also be referred to as a "tablet". The shape of the pellet is not limited, but is usually spherical, elliptical spherical, or cylindrical. The size of the pellet is not limited, and for example, the pellet has an average particle diameter or a circle equivalent diameter of 500 µm or more.

The composition may be molded into a sheet and used. For example, a sheet made of a curable particulate silicone composition having an average thickness of 500 µm or more, preferably several mm, has hot-melt properties and heat-curable properties at a high temperature, and therefore is advantageous in terms of excellent handling workability and excellent melting characteristics, particularly when used for compression molding or the like.

The composition is non-fluid at 25°C. Here, the term "non-fluid" means that it is not deformed or flowed in a no-load condition, and it is preferable that it is not deformed or flowed in a no-load condition at 25°C. when it is molded into a pellet, a tablet, or the like. Such non-fluid can be evaluated, for example, by placing a molded product of the composition on a hot plate at 25°C. and substantially not deforming or flowing under no load or constant weight. This is because, when non-fluid at 25°C., shape retention at this temperature is good and the surface tackiness is low.

The softening point of the composition is preferably 100°C. or less. Such a softening point means a temperature at which the deformation amount in the height direction is 1 mm or more when the deformation amount of the composition is measured after the load is removed by continuing to press the hot plate with a load of 100 grams for 10 seconds from above.

The composition preferably has a melt viscosity at 100°C. of 8000 Pa·s or less, 6000 Pa·s or less, or 5000 Pa·s or less. The melt viscosity at 100°C. is preferably 10 Pa·s or more. This is because the adhesiveness to the base material after the composition is hot-melted and then cooled to 25°C. is good. The melt viscosity referred to herein can be measured at a shear rate of 5[1/s] by a rheometer AR2000EX (manufactured by T.A. Instruments Japan, Inc.) or the like.

In the present composition, since component (B) can be filled in a relatively large amount and a high amount with respect to component (A), it is excellent in handling workability, and in particular, it is excellent in handling workability and moldability during overmold molding. Such a composition preferably does not have a definite glass transition point (Tg) in the range of 25°C. to 200°C., and it is preferable that breakage or defects do not occur during overmold molding due to rapid liquefaction.

The composition has excellent curing characteristics. The curing characteristics of the composition can be evaluated using a rheometer. The curing characteristics of the present composition can be evaluated based on the values of T₁ and T₉₀ for the times (seconds) at which the 1% torque value and the 90% torque value are obtained, respectively, when the torque value after 3 minutes at a constant temperature of 150 to 180°C. is set to 100. The present composition preferably has the T₁ of 20 seconds or more, or 25 seconds or more, as measured at a constant temperature of 150 to 180°C. In addition, the composition preferably has the T₉₀ of 145 seconds or less, or 140 seconds or less, as measured at a temperature of 150 to 180°C. The rheometer used for the measurements is exemplified by a rheometer MDR2000 (manufactured by Alpha Technologies, Inc.).

### Method of producing curable particulate silicone composition

The present composition can be produced by powder-mixing components (A) to (C) and other optional components at a temperature lower than the softening point of component (A). The powder mixer used in the present manufacturing method is not limited, and exemplified are a uniaxial or biaxial continuous mixer, a two-roll mixer, a ROSS mixer, a Hobart mixer, a dental mixer, a planetary mixer, a kneader mixer, a laboratory mixer, a small-sized mill, and a henschel mixer, and preferably, a laboratory mixer and a henschel mixer.

### Method of molding cured product

The composition can be cured by a method comprising at least the following steps (I) to (III).
(I) a step of heating and melting the present composition to the softening point of component (A) or higher;
(II) a step of injecting the curable silicone composition obtained in step (I) into a mold or a step of distributing the curable silicone composition obtained in step (I) to a mold by clamping; and
(III) a step of curing the curable silicone composition injected in step (II).

As described above, the composition of the present invention is hard and tough at a low temperature to a high temperature of the cured product, exhibits characteristic behavior of an average linear expansion coefficient and a storage modulus, and is excellent in handling workability and curing characteristics, it is particularly suitable for overmold molding for semiconductor elements and the like.

In the above steps, a transfer molding machine, a compression molding machine, an injection molding machine, an auxiliary ram molding machine, a slide molding machine, a double ram molding machine, a low pressure sealing molding machine, or the like can be used. In particular, the composition of the present invention can be suitably used for the purpose of obtaining a cured product by transfer molding and compression molding. In particular, a sheet obtained by molding the composition of the present invention is useful as a material for compression molding.

Finally, in step (III), the curable silicone composition injected (applied) in step (II) is cured. When an organic peroxide is used as component (C), the heating temperature is preferably 150°C. or higher or 170°C. or higher.

Since it is suitable as a protective member for a semiconductor or the like, the cured product obtained by curing the present composition preferably has a type-D durometer hardness of 60 or more or 70 or more at 25°C. This type-D durometer hardness is determined by the type-D durometer in accordance with the JIS K 6253-1997 "Hardness Testing Methods for Vulcanized Rubber and Thermoplastic Rubber".

Furthermore, since it is suitable as a sealant for semiconductors which is required to have high hardness and high strength, the bending strength of the cured product measured by the method specified in JIS K 6911-1995 "Testing Methods for Thermosetting Plastics" is preferably 15 MPa or more, or 20 MPa or more.

### Use of composition

Since the composition has hot-melt properties and excellent handling workability and curing properties at the time of melting (hot melt), it is suitable as a sealant and an underfill agent for semiconductors; a sealant for power semiconductors such as SiC and GaN; an adhesive for electricity and electronics, a potting agent, a protective agent, and a coating agent. Since the composition has hot-melt properties, it is also suitable as a material for transfer molding, compression molding, or injection molding. In particular, it is preferable to use the composition as a sealant for semiconductors using an overmold molding method at the time of molding.

### Use of cured product

The application of the cured product of the present invention is not particularly limited, but the composition of the present invention has hot-melt properties, is excellent in moldability and mechanical properties, and the cured product exhibits characteristic behavior of an average linear expansion coefficient and a storage modulus at room temperature to high temperature as described above. Therefore, the cured product obtained by curing the present composition can be suitably used as a member for a semiconductor device, and can be suitably used as a sealant for a semiconductor element, an IC chip or the like, and as an adhesive/bonding member of a conductor device.

There is no particular restriction on a semiconductor device having a member made of the cured product of the present invention, but it is particularly preferable to be a power semiconductor device. As described above, since the cured product obtained by curing the composition of the present invention exhibits characteristic behavior of an average linear expansion coefficient and a storage modulus, it is difficult to cause defects of the cured product against molding and temperature shock, and it is possible to protect the semiconductor element and the circuit board, suppress deterioration thereof, and realize a long life.

### EXAMPLES

The curable particulate liquid silicone composition of the present invention, and the production method thereof are described below in further detail using examples and comparative examples. Note that in the formulas, Me, Ph, and Vi represent a methyl group, a phenyl group, and a vinyl group, respectively. Further, with respect to the curable silicone compositions of Examples and Comparative Examples, the softening point, melt viscosity, curability, moldability, warpage of the molded product, and bending strength, storage modulus, average linear expansion coefficient, and linear expansion coefficient curve of the cured product were measured as follows, and the results are shown in Table 1.

### Softening point of hot-melt silicone

The hot-melt silicone was placed on a hot plate set at 25°C. to 100°C., and the liquefied temperature was used as the softening point while checking the state with a spatula.

### Softening point of curable particulate silicone composition

The curable particulate silicone composition was molded into cylindrical pellets of ϕ14 mm*22 mm. The pellet was placed on a hot plate set at 25°C. to 100°C. and kept pressed from above for 10 seconds with a load of 100 grams, and after the load was removed, the amount of deformation of the pellet was measured. The temperature at which the deformation amount in the height direction was 1 mm or more was defined as the softening point.

### Melt viscosity

The melt viscosities of the hot-melt silicone and curable particulate silicone compositions at 100°C. were measured at a shear rate of 5(1/s) using a rheometer AR2000EX (manufactured by T.A. Instruments Japan K.K.).

### Moldability and Warpage of Molded Product

The curable particulate silicone composition was integrally molded with a lead frame made of copper using a transfer molding machine to produce a molded product having a length of 35 mm, a width of 25 mm, a height of 1 mm. As molding conditions, in Examples 1, 2, 5 to 7, and Comparative Examples 1 to 2, the mold temperature was 150°C. and the mold clamping time was 120 seconds, and in Examples 3 and 4 (peroxide curing), the mold temperature was 180°C. and the mold clamping time was 120 seconds. After the molded product was taken out from the mold, it was cooled to 25°C., and then the presence or absence of cracks and the presence or absence of molding defects such as peeling from the lead frame were visually confirmed. Note that in the formulas, Me, Ph, and Vi represent a methyl group, a phenyl group, and a vinyl group, respectively.

### Storage modulus of cured product

The curable particulate silicone composition was heated at 150°C. for 2 hours to prepare a cured product. The storage modulus of the cured product from -50°C. to 250°C. was measured using a rheometer ARES (manufactured by T.A. Instrument Japan Co., Ltd.) and the values at 25°C. and 150°C. were read. Table 1 shows ratios of measured values at 25°C. and 150°C.

### Average linear expansion coefficient of cured product

The curable silicone composition was heated at 150°C. for 2 hours to prepare a cured product. The average linear expansion coefficient of the cured product in the range of 25°C. to 200°C. was measured by the method specified in JIS K 7197-1991, "Testing method for linear thermal expansion coefficient of plastics by thermomechanical analysis".

### Bending strength of cured product

The curable silicone composition was heated at 150°C. for 2 hours to prepare a cured product. The bending strength of the cured product was measured by the method specified in JIS K 6911-1995 "Testing Methods for Thermosetting Plastics".

### Linear expansion coefficient curve of cured product

The curable silicone composition of Example 1 was cured by the method described above to prepare a cured product. The linear expansion coefficient of the cured product was measured by TM9200 manufactured by Advance Riko, Inc. in a temperature range of 20°C. to 300°C. The results are as shown in FIG. 1, and any definite inflection points were not observed.

x axis is temperature and y axis is change in size

In the other examples, definite inflection points were not observed in the temperature range of 20°C. to 300°C. when the linear expansion coefficient curve of the cured product was drawn.

### Reference Example 1

In a 1-L flask, 270.5 g of a 55 mass% toluene solution of a resinous organopolysiloxane represented by the average unit formula: (PhSiO_{3/2})_{0.80}(Me₂ViSiO_{1/2})_{0.20}, which is a white solid at 25°C.; and 0.034 g of a 1,3-divinyltetramethyldisiloxane solution of platinum 1,3-divinyltetramethyldisiloxane complex (content of platinum metal = about 4000 ppm) were charged, and stirred uniformly at room temperature (25°C.) to prepare a toluene solution of a resinous organopolysiloxane (1) containing platinum metal as mass unit of 10 ppm.
The softening point of this resinous organopolysiloxane (1) was 100°C., and its melt viscosity at 100°C. was 100 Pa·s.

### Reference Example 2

In a 1-L flask, 270.5 g of a 55 mass% toluene solution of a resinous organopolysiloxane represented by the average unit formula: (PhSiO_{3/2})0.80(Me₂ViSiO_{1/2})_{0.20}, which is a white solid at 25°C.; 21.3 g of a diphenylsiloxane in which both ends of the molecular chains were blocked with dimethylhydrogensiloxy groups and which has a viscosity of 5 mPa·s (content of silicon atom bonded hydrogen atoms = 0.6 mass%) represented by the formula: HMe₂SiO(Ph₂SiO)SiMe₂H (at an amount such that the amount of silicon atom bonded hydrogen atoms in this component is 0.5 mol with regard to 1 mol of vinyl groups in the resinous organopolysiloxane); and 0.034 g of a 1,3-divinyltetramethyldisiloxane solution of platinum 1,3-divinyltetramethyldisiloxane complex (content of platinum metal = about 4000 ppm) (at an amount such that platinum metal becomes 10 ppm in terms of mass units with regard to the liquid mixture) were charged, and stirred uniformly at room temperature.
Thereafter, the temperature in the flask was raised to 100°C. by an oil bath, and the mixture was stirred under a reflux of toluene for 2 hours to prepare a toluene solution of an organosiloxane crosslinked product (2) containing a resinous organosiloxane derived from the above-mentioned resinous organopolysiloxane and a chained organosiloxane derived from the above-mentioned diphenylsiloxane and having a vinyl group not involved in the above-mentioned reaction. When the organosiloxane crosslinked product (2) was analyzed by FT-IR, peaks of silicon atom bonded hydrogen atom were not observed. The organosiloxane crosslinked product (2) had a softening point of 75°C. and a melt viscosity of 700 Pa·s at 100°C.

### Reference Example 3

True-spherical hot-melt silicone fine particles (1) were prepared by atomizing the toluene solution of the resinous organopolysiloxane (1) prepared in Reference Example 1 by spray drying at 40°C. while removing toluene. Observation of the fine particles with an optical microscope revealed that the particle diameter was 5 to 10 µm and the average particle diameter was 7.9 µm.

### Reference Example 4

The toluene solution of the organosiloxane crosslinked product (1) prepared in Reference Example 1 was charged into a biaxial kneader heated to 150°C., toluene was removed, and the resultant organosiloxane crosslinked product (1) was pulverized by a ball mill while cooling to prepare hot-melt silicone fine particles (2) of irregular shape. Observation of the fine particles with an optical microscope revealed that the particle diameter was 1000 to 3000 µm and the average particle diameter was 1600 µm.

### Reference Example 5

True-spherical hot-melt silicone fine particles (3) were prepared by atomizing the toluene solution of the organosiloxane crosslinked product (2) prepared in Reference Example 2 by spray drying at 40°C. while removing toluene. Observation of the fine particles with an optical microscope revealed that the particle diameter was 5 to 10 µm and the average particle diameter was 7.5 µm.

### Example 1

78.7 g of hot-melt silicone fine particles (1), 9.1 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%), 12.2 g of branched chain organopolysiloxane having 2 or more silicon atom bonded hydrogen atoms in one molecule and a viscosity of 25 mPa·s, represented by the average unit formula: (PhSiO_{3/2})_{0.4}(HMe₂SiO_{1/2})_{0.6} (content of silicon atom bonded hydrogen atoms = 0.65 mass%) {at an amount such that the amount of silicon atom bonded hydrogen atoms in the above diphenylsiloxane and the above organopolysiloxane is 1.0 mol with regard to 1 mol of vinyl groups in the silicone fine particles (1)}, 1-ethynyl-1-cyclohexanol (at an amount of 300 ppm in terms of mass units with regard to the present composition), and 1181.1 g of a fused silica having an average particle diameter of 15 µm (HS-202 manufactured by Nippon Steel & Sumikin Materials Co., Ltd., Micron Co.) were introduced into a small-sized mill at once, and stirring was performed for 1 minute at room temperature (25°C) to prepare a uniform and white curable particulate silicone composition.
Next, this composition was tableted by a tableting machine to prepare cylindrical pellets having a diameter of 14 mm and a height of 22 mm.
The average linear expansion coefficient curve of the cured product at 20°C. to 300°C. is as shown in FIG. 1, and any definite inflection points were not observed as in the other examples. Further, the bending strength of the cured product was 47 MPa, which was superior to the corresponding Comparative Example 3.

### Example 2

71.4 g of hot-melt silicone fine particles (1), 21.4 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%), 7.1 g of methylphenylpolysiloxane in which both ends of the molecular chain were blocked with dimethylvinylsiloxy groups and which has a viscosity of 1,000 mPa·s, represented by the average formula: Me₂ViSiO(MePhSiO)_{17.5}SiMe₂Vi (content of vinyl groups = 2.1 mass%) {at an amount such that the amount of silicon atom bonded hydrogen atoms in the above diphenylsiloxane is 1.0 mol with regard to 1 mol of vinyl groups in the silicone fine particles (1) and the methylphenylpolysiloxane in which both ends of the molecular chain were blocked with dimethylvinylsiloxy groups}, 1-ethynyl-1-cyclohexanol (at an amount of 300 ppm in terms of mass units with regard to the present composition), and 1214.3 g of a fused silica having an average particle diameter of 15 µm (HS-202 manufactured by Nippon Steel & Sumikin Materials Co., Ltd., Micron Co.) were introduced into a small-sized mill at once, and stirring was performed for 1 minute at room temperature (25°C) to prepare a uniform and white curable particulate silicone composition.
Next, this composition was tableted by a tableting machine to prepare cylindrical pellets having a diameter of 14 mm and a height of 22 mm.

### Example 3

100.0 g of hot-melt silicone fine particles (1), 2.5 g of 2,5-dimethyl-2,5-di(tert-butylperoxy)hexane (having a 10-hour half-life temperature of 118°C.), and 1050.0 g of a spherical silica having an average particle diameter of 15 µm (HS-202 manufactured by Nippon Steel & Sumikin Materials Co., Ltd., Micron Co.) were introduced into a small-sized mill at once, and stirring was performed for 1 minute at room temperature (25°C) to prepare a uniform and white curable particulate silicone composition. Next, this composition was tableted by a tableting machine to prepare cylindrical pellets having a diameter of 14 mm and a height of 22 mm.

### Example 4

90.9 g of hot-melt silicone fine particles (1), 9.1 g of a diphenylsiloxane in which both ends of the molecular chain were blocked with dimethylhydrogensiloxy groups and which has a viscosity of 5 mPa·s (content of silicon atom bonded hydrogen atoms = 0.6 mass%) represented by the formula: HMe₂SiO(Ph₂SiO)SiMe₂H, 2.3 g of 2,5-dimethyl-2,5-di(tert-butylperoxy)hexane (having a 10-hour half-life temperature of 118°C.), and 1022.7 g of a spherical silica having an average particle diameter of 15 µm (HS-202 manufactured by Nippon Steel & Sumikin Materials Co., Ltd., Micron Co.) were introduced into a small-sized mill at once, and stirring was performed for 1 minute at room temperature (25°C) to prepare a uniform and white curable particulate silicone composition.
Next, this composition was tableted by a tableting machine to prepare cylindrical pellets having a diameter of 14 mm and a height of 22 mm.

### Example 5

74.1 g of hot-melt silicone fine particles (3), 11.1 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%), 14.8 g of methylphenylpolysiloxane in which both ends of the molecular chain were blocked with dimethylvinylsiloxy groups and which has a viscosity of 1,000 mPa·s, represented by the average formula: Me₂ViSiO(MePhSiO)_{17.5}SiMe₂Vi (content of vinyl groups = 2.1 mass%) {at an amount such that the amount of silicon atom bonded hydrogen atoms in the above diphenylsiloxane is 1.0 mol with regard to 1 mol of vinyl groups in the silicone fine particles (3) and the methylphenylpolysiloxane in which both ends of the molecular chain were blocked with dimethylvinylsiloxy groups}, 1-ethynyl-1-cyclohexanol (at an amount of 300 ppm in terms of mass units with regard to the present composition), and 1111.1 g of a spherical silica having an average particle diameter of 15 µm (HS-202 manufactured by Nippon Steel & Sumikin Materials Co., Ltd., Micron Co.) were introduced into a small-sized mill at once, and stirring was performed for 1 minute at room temperature (25°C) to prepare a uniform and white curable particulate silicone composition.
Next, this composition was tableted by a tableting machine to prepare cylindrical pellets having a diameter of 14 mm and a height of 22 mm.

### Example 6

78.7 g of hot-melt silicone fine particles (2), 9.1 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%), 12.2 g of branched chain organopolysiloxane having 2 or more silicon atom bonded hydrogen atoms in one molecule and a viscosity of 25 mPa·s, represented by the average unit formula: (PhSiO_{3/2})_{0.4}(HMe₂SiO_{1/2})_{0.6} (content of silicon atom bonded hydrogen atoms = 0.65 mass%) {at an amount such that the amount of silicon atom bonded hydrogen atoms in the above diphenylsiloxane and the above organopolysiloxane is 1.0 mol with regard to 1 mol of vinyl groups in the silicone fine particles (2)}, 1-ethynyl-1-cyclohexanol (at an amount of 300 ppm in terms of mass units with regard to the present composition), and 1181.1 g of a fused silica having an average particle diameter of 15 µm (HS-202 manufactured by Nippon Steel & Sumikin Materials Co., Ltd., Micron Co.) were introduced into a small-sized mill at once, and stirring was performed for 1 minute at room temperature (25°C) to prepare a uniform and white curable particulate silicone composition.
Next, this composition was tableted by a tableting machine to prepare cylindrical pellets having a diameter of 14 mm and a height of 22 mm.

### Example 7

71.4 g of hot-melt silicone fine particles (1), 21.4 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%), 7.1 g of methylphenylpolysiloxane in which both ends of the molecular chain were blocked with dimethylvinylsiloxy groups and which has a viscosity of 1,000 mPa·s, represented by the average formula: Me₂ViSiO(MePhSiO)_{17.5}SiMe₂Vi (content of vinyl groups = 2.1 mass%) {at an amount such that the amount of silicon atom bonded hydrogen atoms in the above diphenylsiloxane is 1.0 mol with regard to 1 mol of vinyl groups in the silicone fine particles (1) and the methylphenylpolysiloxane in which both ends of the molecular chain were blocked with dimethylvinylsiloxy groups}, 1-ethynyl-1-cyclohexanol (at an amount of 300 ppm in terms of mass units with regard to the present composition), and 1571.4 g of a spherical alumina having an average particle diameter of 12 µm (AS-40 manufactured by Showa Denko K.K.) were introduced into a small-sized mill at once, and stirring was performed for 1 minute at room temperature (25°C) to prepare a uniform and white curable particulate silicone composition.
Next, this composition was tableted by a tableting machine to prepare cylindrical pellets having a diameter of 14 mm and a height of 22 mm.

### Comparative Example 1

89.3 g of hot-melt silicone fine particles (3), 5.4 g of diphenylsiloxane in which both ends of the molecular chain were blocked with dimethylhydrogensiloxy groups and which has a viscosity of 5 mPa·s, represented by the formula: HMe₂SiO(Ph₂SiO)SiMe₂H (content of silicon atom bonded hydrogen atoms = 0.6 mass%), 5.4 g of branched chain organopolysiloxane having 2 or more silicon atom bonded hydrogen atoms in one molecule and a viscosity of 25 mPa·s, represented by the average unit formula: (PhSiO_{3/2})_{0.4}(HMe₂SiO_{1/2})_{0.6} (content of silicon atom bonded hydrogen atoms = 0.65 mass%) {at an amount such that the amount of silicon atom bonded hydrogen atoms in the above diphenylsiloxane and the above organopolysiloxane is 1.0 mol with regard to 1 mol of vinyl groups in the silicone fine particles (3)}, 1-ethynyl-1-cyclohexanol (at an amount of 300 ppm in terms of mass units with regard to the present composition), and 401.8 g of a spherical silica having an average particle diameter of 15 µm (HS-202 manufactured by Nippon Steel & Sumikin Materials Co., Ltd., Micron Co.) were introduced into a small-sized mill at once, and stirring was performed for 1 minute at room temperature (25°C) to prepare a uniform and white curable particulate silicone composition.
Next, this composition was tableted by a tableting machine to prepare cylindrical pellets having a diameter of 14 mm and a height of 22 mm.

### Comparative Example 2

68.2 g of methylvinylphenylpolysiloxane represented by the average unit formula: (MeViSiO_{2/2})_{0.25}(Ph₂SiO_{2/2})_{0.30}(PhSiO_{3/2})_{0.45}(HO_{1/2})_{0.02}, 9.1 g of a dimethylvinylsiloxy-terminated polymethylphenylsiloxane represented by the average formula: ViMe₂SiO(MePhSiO)_{17.5}SiViMe₂, 22.7 g of 1,1,5,5-tetramethyl-3,3-diphenyltrisiloxane represented by the formula: (HMe₂SiO)₂SiPh₂ (at an amount such that the amount of silicon atom bonded hydrogen atoms in this component is 1.15 mol with regard to 1 mol of total vinyl groups in the above-mentioned methylvinylphenylpolysiloxane and dimethylvinylsiloxy-terminated polymethylphenylsiloxane), a 1,3-divinyl-1,1,3,3-tetramethyldisiloxane solution of platinum 1,3-divinyl-1,1,3,3-tetramethyldisiloxane complex (at an amount such that platinum metal becomes 5.0 ppm in terms of mass units with regard to the present composition), 1-ethynyl-1-cyclohexanol (at an amount of 300 ppm in terms of mass units with regard to the present composition), and 300.0 g of a spherical silica having an average particle diameter of 15 µm (HS-202 manufactured by Nippon Steel & Sumikin Materials Co., Ltd., Micron Co.) were blended to prepare a pasty curable silicone composition having a viscosity at 25°C. of 620 Pa·s.

When this composition was heated at 120°C. for 10 minutes, the resulting product was a solid whose viscosity could not be measured at 25°C. and had hot-melt properties to fluidize when heated to 100°C. or higher. This composition was fluidized at 100°C. or higher and then heated at 150°C. for 10 minutes, whereupon the hot meltability was lost. This composition was poured into a Teflon (registered trademark) tube having a diameter of 14 mm and heated at 120°C. for 10 minutes to prepare cyrindrical pellets having a height of 22 mm.

### Comparative Example 3

24.2 g of methylvinylpolysiloxane in which both ends of the molecular chain were blocked with hydroxyl groups and which has a linear methylvinylsiloxane block represented by the formula: -(MeViSiO_{2/2})₆-, 22.5 g of dimethylpolysiloxane in which both ends of the molecular chain were blocked with dimethylvinylsiloxy groups, represented by the formula: Me₂ViSiO(Me₂SiO)₄₆SiMe₂Vi, 40.0 g of a spherical silica having an average particle diameter of 15 µm (HS-202 manufactured by Nippon Steel & Sumikin Materials Co., Ltd., Micron Co.), 11.0 g of n-octyltriethoxysilane, and 11.0 g of dimethylpolysiloxane in which one end of the molecular chain was blocked with a trimethylsiloxy group and another end of the molecular chain was blocked with a trimethoxysiloxy group and which has a viscosity of 125 mPa·s, represented by the formula: Me₃SiO(Me₂SiO)₁₁₀Si(OMe)₃ were charged in a Ross mixer, mixed at room temperature, and kneaded while heating at 150°C. under reduced pressure to prepare a silicone base.

Next, at room temperature, to the silicone base, 22.5 g of methylhydrogenpolysiloxane in which both ends of the molecular chain were blocked with trimethylsiloxy groups and which has a linear methylhydrogensiloxane block represented by the formula: -(MeHSiO_{2/2})₅₀- (at an amount such that the amount of silicon atom bonded hydrogen atoms in this component is 1.5 mol with regard to 1 mol of total of the vinyl groups in methylvinylpolysiloxane of the silicone base and the vinyl groups of dimethylpolysiloxane in which both ends of the molecular chain were blocked with dimethylvinylsiloxy groups), 5.5 g of a condensation reaction product of dimethylsiloxane-methylvinylsiloxane copolymerization oligomer (in which both ends of the molecular chain were blocked with hydroxyl groups) and 3-glycidoxypropyltrimethoxysilane at a mass ratio of 1: 2, which has a viscosity of 20 mPa·s, and 1-ethynyl-1-cyclohexanol (at an amount of 200 ppm in terms of mass units with regard to the present composition) were blended, a 1,3-divinyl-1,1,3,3-tetramethyldisiloxane solution of platinum 1,3-divinyl-1,1,3,3-tetramethyldisiloxane (at an amount such that platinum metal becomes 3 ppm in terms of mass units with regard to the present composition) was further blended to prepare a pasty curable silicone composition having a viscosity of 340 Pa·s at 25°C.
Here, the bending strength of the cured product obtained by curing the liquid curable silicone composition was 15 MPa, which was largely inferior to the cured product of Example 1.

### Comparative Example 4

55.2 g of methylvinylphenylpolysiloxane represented by the average unit formula: (MeViSiO_{2/2})_{0.15}(Me₂SiO_{2/2})_{0.15}(Ph₂SiO_{2/2})_{0.30}(PhSiO_{3/2})_{0.40}(HO_{1/2})_{0.04}, 13.8 g of 1,3,5,7-tetramethyl-1,3,5,7-tetravinylcyclotetrasiloxane represented by the formula: (MeViSiO)₄, 30.9 g of 1,1,5,5-tetramethyl-3,3-diphenyltrisiloxane represented by the formula: (HMe₂SiO)₂SiPh₂ (at an amount such that the amount of silicon atom bonded hydrogen atoms in this component is 0.9 mol with regard to 1 mol of total vinyl groups in the above-mentioned methylvinylphenylpolysiloxane and 1,3,5,7-tetramethyl-1,3,5,7-tetravinylcyclotetrasiloxane), a 1,3-divinyl-1,1,3,3,-tetramethyldisiloxane solution of platinum 1,3-divinyl-1,1,3,3,-tetramethyldisiloxane (at an amount such that platinum metal becomes 3.5 ppm in terms of mass units with regard to the present composition), 1-ethynyl-1-cyclohexanol (at an amount of 200 ppm in terms of mass units with regard to the present composition), and 400.0 g of a spherical silica having an average particle diameter of 15 µm (HS-202 manufactured by Nippon Steel & Sumikin Materials Co., Ltd., Micron Co.) were blended to prepare a pasty curable silicone composition having a viscosity of 104 Pa·s.

**Table 1**

| | Example 1 | Example 2 | Example 3 | Example 4 | Example 5 | |
|---|---|---|---|---|---|---|
| Properties of curable liquid silicone composition | 80 | 80 | 90 | 90 | 65 | |
| Softening point (°C.) | | | | | | |
| Melt viscosity (Pa·s) | 1840 | 1520 | 2630 | 2580 | 3620 | |
| Moldability | Favorable | Favorable | Favorable | Favorable | Favorable | |

| Properties of Cured Product | | | | | | |
|---|---|---|---|---|---|---|
| Ratio of storage modulus 25°C./150°C. | 1/15 | 1/32 | 1/18 | 1/23 | 1/38 | |
| Average linear expansion coefficient (ppm/°C.) | 16 | 18 | 15 | 15 | 19 | |
| Warpage of Molded Product (mm) | <1 | <1 | <1 | <1 | <1 | |
| Bending strength (MPa) | 47 | 54 | 53 | 58 | 45 | |

| | Example 6 | Example 7 | Comparative Example 1 | Comparative Example 2 | Comparative Example 3 | Comparative Example 4 |
|---|---|---|---|---|---|---|
| Properties of curable liquid silicone composition | 85 | 80 | 65 | 55 | N/A | N/A |
| Softening point (°C.) | | | | | | |
| Melt viscosity (Pa·s) | 2470 | 2110 | 2620 | 850 | N/A | N/A |
| Moldability | Favorable | Favorable | Favorable | Favorable | Crack | Peeling |
| | | | | | | |

| Properties of Cured Product | | | | | | |
|---|---|---|---|---|---|---|
| Ratio of storage modulus 25°C./150°C. | 1/20 | 1/23 | 1/90 | 1/280 | 1/3 | 1/64 |
| Average linear expansion coefficient (ppm/°C.) | 19 | 16 | 33 | 50 | 19 | 107 |
| Warpage of Molded Product (mm) | <1 | <1 | 3 | <1 | 5 | 3 |
| Bending strength (MPa) | 35 | 45 | 44 | 25 | 15 | 17 |

## Claims

1. A curable particulate silicone composition comprising:
(A) 100 parts by mass of hot-melt silicone fine particles having an average primary particle diameter observed with an optical microscope of 1 to 5000 µm, having a softening point of 30°C. or higher measured as defined in the description and having a hydrosilylation reactive group and/or a radical reactive group;
(B) 500 to 4000 parts by mass of an inorganic filler having an average particle diameter observed with an optical microscope of 10.0 µm or more and
(C) a curing agent,
wherein when cured, the curable particulate silicone composition provides a cured product that has an average linear expansion coefficient measured as defined in the description, at temperature range of 25°C. to 200°C. of 30 ppm/°C. or less and the ratio of the value of the storage modulus at -50°C. (G'₋₅₀) to the value of the storage modulus at 250°C. (G'₂₅₀): (G'₋₅₀/G'₂₅₀) is in the range of 1/1 to 1/50, wherein each storage modulus is measured using a rheometer.

2. The curable particulate silicone composition according to claim 1, wherein component (B) is a filler that does not have a softening point or does not soften below the softening point of component (A).

3. The curable particulate silicone composition according to claim 1 or 2, wherein component (B) is a reinforcing filler, a white pigment, a thermally conductive filler, a conductive filler, a phosphor, or a mixture of at least two of these.

4. The curable particulate silicone composition according to any one of claims 1 to 3, wherein component (B) is a spherical inorganic filler having an average particle diameter observed with an optical microscope of 10.0 µm or more.

5. The curable particulate silicone composition according to claim 1, wherein component (A) is silicone fine particles comprising (A₁) a resinous organopolysiloxane, (A₂) an organopolysiloxane crosslinked product obtained by partially crosslinking at least one organopolysiloxane, (A₃) a block copolymer composed of a resinous organosiloxane block and a chained organosiloxane block, or a mixture of at least two of these.

6. The curable particulate silicone composition according to claim 1 or 5, wherein component (A) is true-spherical silicone fine particles in which 10 mol % or more of the silicon atom-bonded organic groups in component (A) is an aryl group and the average primary particle diameter observed with an optical microscope thereof is 1 to 10 µm.

7. The curable particulate silicone composition according to any one of claims 1 to 6, wherein the cured product obtained by curing does not have a definite inflection point in a change in the linear expansion coefficient at a temperature range of 20°C. to 300°C.

8. The curable particulate silicone composition according to any one of claims 1 to 7, wherein the curable particulate silicone composition is in the form of pellets or sheets.

9. A cured product formed by curing the curable particulate silicone composition according to any one of claims 1 to 8.

10. Use of the cured product according to claim 9 as a member for a semiconductor device.

11. A semiconductor device comprising the cured product according to claim 9.

12. A power semiconductor device having a structure in which a semiconductor element or a semiconductor circuit board is overmolded with the cured product according to claim 9.

13. A method of molding a cured product, comprising at least the following steps (I) to (III):
(I) a step of heating and melting the curable particulate silicone composition according to any one of claims 1 to 8 to the softening point of component (A) or higher;
(II) a step of injecting the curable silicone composition obtained in step (I) into a mold or a step of distributing the curable silicone composition obtained in step (I) to a mold by clamping; and
(III) a step of curing the curable silicone composition injected in step (II).

## Patentansprüche

1. Eine härtbare partikelförmige Silikonzusammensetzung, die Folgendes beinhaltet:
(A) 100 Masseteile feiner Partikel heißschmelzenden Silikons mit einem mit einem Lichtmikroskop beobachteten durchschnittlichen Primärpartikeldurchmesser von 1 bis 5000 µm, mit einem Erweichungspunkt von 30 °C oder höher, wie in der Beschreibung definiert gemessen, und mit einer hydrosilylierungsreaktiven Gruppe und/oder einer radikalreaktiven Gruppe;
(B) 500 bis 4000 Masseteile eines anorganischen Füllstoffs mit einem mit einem Lichtmikroskop beobachteten durchschnittlichen Partikeldurchmesser von 10,0 µm oder mehr und
(C) ein Härtungsmittel,
wobei die härtbare partikelförmige Silikonzusammensetzung, wenn gehärtet, ein gehärtetes Produkt bereitstellt, das in einem Temperaturbereich von 25 °C bis 200 °C einen durchschnittlichen Längenausdehnungskoeffizienten, wie in der Beschreibung definiert gemessen, von 30 ppm/°C oder weniger aufweist, und wobei das Verhältnis des Wertes des Speichermoduls bei -50 °C (G'₋₅₀) zu dem Wert des Speichermoduls bei 250 °C (G'₂₅₀): (G'₋₅₀/G'₂₅₀) in dem Bereich von 1 : 1 bis 1 : 50 liegt, wobei jeder Speichermodul unter Verwendung eines Rheometers gemessen wird.

2. Härtbare partikelförmige Silikonzusammensetzung gemäß Anspruch 1, wobei die Komponente (B) ein Füllstoff ist, der keinen Erweichungspunkt aufweist oder der unterhalb des Erweichungspunktes der Komponente (A) nicht weich wird.

3. Härtbare partikelförmige Silikonzusammensetzung gemäß Anspruch 1 oder 2, wobei die Komponente (B) ein verstärkender Füllstoff, ein weißes Pigment, ein thermisch leitender Füllstoff, ein leitender Füllstoff, ein Leuchtstoff oder eine Mischung von mindestens zwei von diesen ist.

4. Härtbare partikelförmige Silikonzusammensetzung gemäß einem der Ansprüche 1 bis 3, wobei die Komponente (B) ein kugelförmiger anorganischen Füllstoff mit einem mit einem Lichtmikroskop beobachteten durchschnittlichen Partikeldurchmesser von 10,0 µm oder mehr ist.

5. Härtbare partikelförmige Silikonzusammensetzung gemäß Anspruch 1, wobei es sich bei der Komponente (A) um feine Silikonpartikel handelt, die (A₁) ein harzartiges Organopolysiloxan, (A₂) ein durch partielles Vernetzen mindestens eines Organopolysiloxans erhaltenes vernetztes Organopolysiloxanprodukt, (A₃) ein aus einem Block harzartigen Organosiloxans und einem Block kettenförmigen Organosiloxans zusammengesetztes Blockcopolymer oder eine Mischung von mindestens zwei von diesen beinhalten.

6. Härtbare partikelförmige Silikonzusammensetzung gemäß Anspruch 1 oder 5, wobei es sich bei der Komponente (A) um feine, richtig kugelförmige Silikonpartikel handelt, bei denen 10 Mol-% oder mehr der siliciumatomgebundenen organischen Gruppen in der Komponente (A) eine Arylgruppe sind und der mit einem Lichtmikroskop beobachtete durchschnittliche Primärpartikeldurchmesser davon 1 bis 10 µm beträgt.

7. Härtbare partikelförmige Silikonzusammensetzung gemäß einem der Ansprüche 1 bis 6, wobei das durch Härten erhaltene gehärtete Produkt in einem Temperaturbereich von 20 °C bis 300 °C keinen eindeutigen Wendepunkt einer Änderung des Längenausdehnungskoeffizienten aufweist.

8. Härtbare partikelförmige Silikonzusammensetzung gemäß einem der Ansprüche 1 bis 7, wobei die härtbare partikelförmige Silikonzusammensetzung in der Gestalt von Pellets oder Platten vorliegt.

9. Ein gehärtetes Produkt, das durch Härten der härtbaren partikelförmigen Silikonzusammensetzung gemäß einem der Ansprüche 1 bis 8 gebildet wird.

10. Eine Verwendung des gehärteten Produktes gemäß Anspruch 9 als ein Bauteil für ein Halbleiterbauelement.

11. Ein Halbleiterbauelement, das das gehärtete Produkt gemäß Anspruch 9 beinhaltet.

12. Ein Leistungshalbleiterbauelement, das eine Struktur aufweist, bei der ein Halbleiterelement oder eine Halbleiterplatine mit dem gehärteten Produkt gemäß Anspruch 9 umspritzt ist.

13. Ein Verfahren zum Formen eines gehärteten Produktes, das mindestens die folgenden Schritte (I) bis (III) beinhaltet:
(I) einen Schritt des Erwärmens und Schmelzens der härtbaren partikelförmigen Silikonzusammensetzung gemäß einem der Ansprüche 1 bis 8 bis zu dem Erweichungspunkt der Komponente (A) oder höher;
(II) einen Schritt des Einspritzens der in Schritt (I) erhaltenen härtbaren Silikonzusammensetzung in eine Form oder einen Schritt des Verteilens der in Schritt (I) erhaltenen härtbaren Silikonzusammensetzung auf eine Form durch Klemmen; und
(III) einen Schritt des Härtens der in Schritt (II) eingespritzten härtbaren Silikonzusammensetzung.

## Revendications

1. Une composition de silicone particulaire durcissable comprenant :
(A) 100 parties en masse de particules fines de silicone thermofusible ayant un diamètre moyen des particules primaires observé avec un microscope optique de 1 à 5 000 µm, ayant un point de ramollissement de 30 °C ou un point plus élevé mesuré tel que défini dans la description et ayant un groupe réactif à l'hydrosilylation et/ou un groupe réactif aux radicaux ;
(B) 500 à 4 000 parties en masse d'une charge inorganique ayant un diamètre moyen des particules observé avec un microscope optique de 10,0 µm ou plus ; et
(C) un agent de durcissement,
où lorsqu'elle est durcie, la composition de silicone particulaire durcissable fournit un produit durci qui a un coefficient de dilatation linéaire moyen mesuré tel que défini dans la description, à un intervalle de température de 25 °C à 200 °C de 30 ppm/°C ou moins et le rapport de la valeur du module de conservation à -50 °C (G'₋₅₀) à la valeur du module de conservation à 250 °C (G'₂₅₀):(G'₋₅₀/G'₂₅₀) est dans l'intervalle de 1/1 à 1/50, où chaque module de conservation est mesuré à l'aide d'un rhéomètre.

2. La composition de silicone particulaire durcissable selon la revendication 1, où le constituant (B) est une charge qui n'a pas un point de ramollissement ou qui ne ramollit pas au-dessous du point de ramollissement du constituant (A).

3. La composition de silicone particulaire durcissable selon la revendication 1 ou la revendication 2, où le constituant (B) est une charge renforçante, un pigment blanc, une charge thermoconductrice, une charge conductrice, un phosphore, ou un mélange d'au moins deux de ceux-ci.

4. La composition de silicone particulaire durcissable selon l'une quelconque des revendications 1 à 3, où le constituant (B) est une charge inorganique sphérique ayant un diamètre moyen des particules observé avec un microscope optique de 10,0 µm ou plus.

5. La composition de silicone particulaire durcissable selon la revendication 1, où le constituant (A) est des particules fines de silicone comprenant (A₁) un organopolysiloxane résineux, (A₂) un produit réticulé d'organopolysiloxane obtenu par réticulation partielle d'au moins un organopolysiloxane, (A₃) un copolymère bloc composé d'un bloc organosiloxane résineux et d'un bloc organosiloxane à chaîne, ou un mélange d'au moins deux de ceux-ci.

6. La composition de silicone particulaire durcissable selon la revendication 1 ou la revendication 5, où le constituant (A) est des particules fines de silicone véritablement sphériques dans lesquelles 10 % en moles ou plus des groupes organiques liés à un atome de silicium dans le constituant (A) est un groupe aryle et le diamètre moyen des particules primaires de celui-ci observé avec un microscope optique est de 1 à 10 µm.

7. La composition de silicone particulaire durcissable selon l'une quelconque des revendications 1 à 6, où le produit durci obtenu par durcissement n'a pas un point d'inflexion définitif dans un changement du coefficient de dilatation linéaire à un intervalle de température de 20 °C à 300 °C.

8. La composition de silicone particulaire durcissable selon l'une quelconque des revendications 1 à 7, où la composition de silicone particulaire durcissable est sous forme de granulés ou de feuilles.

9. Un produit durci formé par durcissement de la composition de silicone particulaire durcissable selon l'une quelconque des revendications 1 à 8.

10. Utilisation du produit durci selon la revendication 9 comme élément pour un dispositif semi-conducteur.

11. Un dispositif semi-conducteur comprenant le produit durci selon la revendication 9.

12. Un dispositif semi-conducteur de puissance ayant une structure dans laquelle une unité semi-conductrice ou une carte de circuit semi-conductrice est surmoulée avec le produit durci selon la revendication 9.

13. Un procédé de moulage d'un produit durci, comprenant au moins les étapes (I) à (III) suivantes :
(I) une étape de chauffage et de fusion de la composition de silicone particulaire durcissable selon l'une quelconque des revendications 1 à 8 jusqu'au point de ramollissement du constituant (A) ou un point plus élevé ;
(II) une étape d'injection de la composition de silicone durcissable obtenue à l'étape (I) dans un moule ou une étape de distribution de la composition de silicone durcissable obtenue à l'étape (I) dans un moule par serrage ; et
(III) une étape de durcissement de la composition de silicone durcissable injectée à l'étape (II).
